# EUROPEAN PATENT SPECIFICATION

(11) **EP 2 840 591 B1**
(45) Date of publication and mention of the grant of the patent: **01.01.2020**
(21) Application number: 13778433.6
(22) Date of filing: 16.04.2013
(51) Int. Cl.: H01L 21/306, B24B 37/04, C09K 3/14, C09G 1/02, H01L 21/02

(54) **METHOD FOR POLISHING A SILICON WAFER**
VERFAHREN ZUM POLIEREN EINES SILICIUMWAFERS
PROCEDE DE POLISSAGE D'UNE TRANCHE DE SILICIUM

(30) Priority: 17.04.2012 JP 2012094240
(43) Date of publication of application: 25.02.2015
(73) Proprietor: Kao Corporation, Chuo-Ku Tokyo 103-8210 (JP)
(72) Inventor: MIURA Joji, Wakayama-shi, Wakayama 640-8580 (JP); MATSUI Yoshiaki, Wakayama-shi, Wakayama 6404-8580 (JP); KATO Yuki, Wakayama-shi, Wakayma 640-8580 (JP); KOTAKA Yuki, Sumida-ku, Tokyo 131-8501 (JP)
(74) Representative: Hoffmann Eitle
(86) International application number: PCT/JP2013/061326
(87) International publication number: WO 2013/157554

(56) References cited:
- EP-A1- 1 870 928
- WO-A1-2011/058952
- JP-A- 2009 123 880
- JP-A- 2010 010 167
- US-A1- 2007 175 104
- US-A1- 2010 267 315
- US-A1- 2011 053 462

## Description

### Technical Field

The present invention relates to a method for manufacturing a semiconductor substrate by using a polishing liquid composition for a silicon wafer and to the use of said composition for polishing a silicon wafer.

### Background Art

Recently, the design rule for semiconductor devices have become more minute due to the increasing demand for the trend of higher recording capacity of a semiconductor memory. As a result, in a photolithography performed in the process of manufacturing the semiconductor device, the depth of focus is decreased, and the demand for the defect reduction and smoothness of silicon wafer (bare wafer) has become even further strict.

For improving the quality of a silicon wafer, polishing of the silicon wafer is performed in multi-stages. In particular, a final polishing performed in the final stage of the polishing is performed to suppress the surface roughness (haze) and also suppress surface defects (LDP: Light Point Defects) such as particles, scratches and pits, which is achieved by improving wettability (hydrophilicity) of the polished silicon wafer surface.

The size of the surface defects permissible for the silicon wafer surface has been decreased year after year. In general, the defect is measured by irradiating a wafer surface with a laser beam and detecting scattered light at that time. Therefore, for measuring more minute defects, it is required to reduce the surface roughness (haze) of the silicon wafer thereby improving the S/N ratio at the time of defect measurement.

For the polishing liquid composition used for final polishing, a polishing liquid composition for chemical-mechanical polishing by use of colloidal silica and an alkali compound is known. Furthermore, a water-soluble polymer compound is added further to the above-mentioned polishing liquid composition in order to make a polishing liquid composition for improving further the haze level, and such a polishing liquid composition is reported (Patent document 1). Further, as a polishing liquid composition for decreasing the number of surface defects (LPD), a polishing liquid composition including a water-soluble macromolecular compound including a nitrogen-containing group is known (Patent document 2).

Further, it has been disclosed that a polishing liquid composition containing a water-soluble macromolecular compound such as an acrylic amide derivative forms a protective film with respect to the metal surface so as to suppress corrosion, thereby improving the planarity (Patent document 3). And Patent document 4 suggests a polishing liquid containing silica sol and a N-alkyl substitution product of acrylamide as a polishing liquid for metal. The polishing liquid allows a speedy polishing, improves planarity, rarely forms a groove between a wiring and an insulating layer, and it has a high storage stability.

### Prior Art Documents

### Patent documents

Patent document 1: JP 2004-128089
Patent document 2: JP 2008-53415
Patent document 3: WO 2007/055278
Patent document 4: JP 2008-91524

US 2011/053462 describes a chemical mechanical polishing aqueous dispersion including (A) silica particles, and (B1) an organic acid, the sodium content, the potassium content, and the ammonium ion content of the silica particles (A) determined by ICP atomic emission spectrometry, ICP mass spectrometry, or ammonium ion quantitative analysis using ion chromatography having a relationship in which the sodium content is 5 to 500 ppm and at least one of the potassium content and the ammonium ion content is 100 to 20,000 ppm.

EP 1 870 928 describes a polishing composition for polishing a wiring metal, ensuring that etching and erosion are suppressed and the residual wiring metal on the portion other than wiring is decreased. The polishing composition comprises (A) an azole group-containing compound having 3 or more azole groups within the molecule and a molecular weight of 300 to 15,000, (B) an oxidant, and (C) one, two or more acids selected from the group consisting of an amino acid, an organic acid and an inorganic acid is provided.

US 2007/175104 is directed to a polishing slurry for polishing a silicon oxide film on polysilicon, which contains an abrasive, polysilicon polishing inhibitor, and water. As the polishing inhibitor, it is preferable to use (1) a water-soluble polymer having a N-monosubstituted or N,N-disubstituted skeleton substituted by any member selected from the group consisting of acrylamide, methacrylamide, and alpha-substituted derivatives thereof, (2) polyethylene glycol, (3) an oxyethylene adduct of an acetylene-based diol, (4) a water-soluble organic compound having an acetylene bond, (5) an alkoxylated linear aliphatic alcohol, or (6) a copolymer containing polyvinyl pyrrolidone or vinyl pyrrolidone.

### Disclosure of Invention

### Problem to be Solved by the Invention

In the polishing liquid composition described in Patent document 1, hydroxyethyl cellulose (HEC) and polyethylene oxide (PEO) are included in order to reduce the surface roughness (haze). However, as HEC is made from natural cellulose as a natural material, a water-insoluble matter derived from cellulose is included, which renders the quality instable. And as the water-insoluble matter become cores for agglomeration of silica particles, the storage stability of the polishing liquid composition deteriorates, and the agglomerate of the silica particles increases the number of surface defects (LPD). In some cases, the presence of the water-insoluble matter itself may increase the number of the surface defects (LPD). Therefor, in order to remove the agglomerate of silica particles and the water-insoluble matter, in general the polishing liquid composition is filtered immediately before its application. However, since the polishing liquid composition has a high viscosity due to the dissolved HEC and the filter clogs up due to the presence of the water-insoluble matter etc., it is required to lower the filtering precision. As a result, removal of the silica particle agglomerate and the water-insoluble matter is insufficient thereby causing degradation of the productivity of silicon wafers.

In the polishing liquid composition described in Patent document 2, at least one kind of water-soluble macromolecule selected from the group consisting of polyvinyl pyrrolidone and poly(N-vinyl formamide) is included to reduce the surface defects (LPD). However, it is impossible to reduce the haze sufficiently by polishing with the polishing liquid composition.

Therefore, the present invention uses: a polishing liquid composition for a silicon wafer, which is superior to a conventional polishing liquid composition for a silicon wafer in storage stability of the polishing liquid composition, and which can reduce the surface roughness (haze) and the surface defects (LPD) of the silicon wafer while ensuring the polishing rate to keep a favorable productivity; a method for manufacturing a semiconductor substrate by using the polishing liquid composition for a silicon wafer; and a use of the composition for polishing a silicon wafer.

### Means for Solving Problem

The present invention is defined by the appended claims.

A polishing liquid composition for a silicon wafer used in the present invention contains components A-C below. The polishing liquid composition for a silicon wafer at 25ºC has pH in the range of 8.0 to 12.0.
(Component A): silica particles
(Component B): at least one nitrogen-containing basic compound selected from the group consisting of an amine compound and an ammonium compound
(Component C): water-soluble macromolecular composition including 10 wt% or more of a constitutional unit I represented by a general formula (1) below and having a weight average molecular weight of 50,000 or more and 1,500,000 or less, 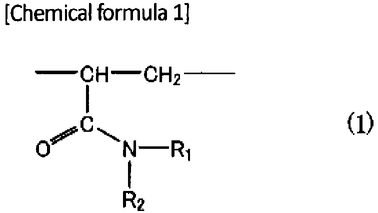 in the above general formula (1), R₁ and R₂ each independently represents a hydrogen, a C1-C8 alkyl group or a C1-C2 hydroxyalkyl group, where R₁ and R₂ are never both hydrogens.

The method for manufacturing a semiconductor substrate of the present invention includes a step of polishing a silicon wafer by using the polishing liquid composition for a silicon wafer of the present invention.

The present invention also relates to the use of the polishing liquid composition for polishing a silicon wafer.

### Effects of the Invention

The method and the use of the present invention utilize a polishing liquid composition for a silicon wafer, which is excellent in the storage stability of the polishing liquid composition and which can reduce the surface roughness (haze) and surface defects (LPD) of the silicon wafer while ensuring a polishing rate to keep a favorable productivity.

### Description of the Invention

The present invention is based on a finding that a water-soluble macromolecular compound including 10 wt% or more of the constitutional unit I represented by the general formula (1) above and having a weight average molecular weight of 50,000 or more and 1,500,000 or less is included in a polishing liquid composition for a silicon wafer (hereinafter it may be stated simply as "polishing liquid composition") so that the storage stability of the polishing liquid composition is improved and it is possible to ensure the polishing rate to keep the favorable productivity (hereinafter, it may be stated simply as "ensuring a polishing rate") and also to reduce the surface roughness (haze) and the surface defects (LPD) of the silicon wafer.

At present, as the polishing liquid composition used for polishing a silicon wafer, a polishing liquid composition including hydroxyl ethyl cellulose (HEC) as the water-soluble macromolecular compound is known in general. However, the HEC is made from natural cellulose, and thus HEC includes water-insoluble matters derived from cellulose and may cause problems such as increasing the number of surface defects. Therefore, it is required to remove the water-insoluble matter from the HEC aqueous solution before application for preparation of the polishing liquid composition. And furthermore, for removing silica agglomerate that is generated around cores of the remaining water-insoluble matter, there is a necessity of filtering the polishing liquid composition after preparation of the polishing liquid composition and in particular, immediately before performing the polishing. Filtering has been known as a method for removing the water-insoluble matter. However, a HEC aqueous solution has a high viscosity although HEC is water soluble. Therefore, the filter will clog up soon if the filtering precision is not lowered, and production of the polishing liquid composition is interrupted. As a result, the remaining water-insoluble matter causes instability in quality or degradation in storage stability of the polishing liquid composition. It is difficult to industrially use such a polishing liquid composition.

In light of this, it is expected to solve the problem by replacing the HEC by at least one kind of synthetic macromolecular compound selected from the group consisting of polyvinyl pyrrolidone and poly(N-vinyl formamide). However, even by adding the synthetic macromolecular compound to the polishing liquid composition, sufficient effects cannot be achieved in reducing the surface roughness (haze) and the surface defects (LPD) of the object to be polished.

In contrast, in the present invention, a water-soluble macromolecular compound including 10 wt% or more of the constitutional unit I represented by the above described general formula (1) and having a weight average molecular weight of 50,000 or more and 1,500,000 or less is used as a substitute of HEC. Thereby, the storage stability of the polishing liquid composition is improved, and furthermore, it is possible to raise the effect of reducing the surface roughness (haze) and surface defects (LPD) of the object that has been polished with the polishing liquid composition, and the polishing rate can be ensured. Although the details of the mechanism of developing the effect of the present invention has not been clarified, it is assumed as follows.

The surface roughness (haze) of an object polished by use of the polishing liquid composition is under influences of a cutting force proportional to the size of the polishing particles (particle diameter) and a degree of corrosion caused by a nitrogen-containing basic compound as a polishing accelerator. In a case where the water-soluble macromolecular compound used for preparation of the polishing liquid composition has a weak interaction with the silica particles, agglomerate between the silica particles cannot be suppressed, the storage stability of the polishing liquid composition deteriorates, and the particle diameter of the secondary agglomerate of the silica particles is increased. As a result, the cutting force is increased, the surface roughness is degraded and the surface defects (LPD) is increased. On the other hand, in a case where the water-soluble macromolecular compound used for preparation of the polishing liquid composition has a weak interaction with the silicon wafer, it is considered that the corrosion of the silicon wafer proceeds, and the nitrogen-containing basic compound causes the roughness of the silicon wafer surface. However, the water-soluble macromolecular compound (component C) has a predetermined weight average molecular weight, includes 10 wt% or more of the constitutional unit I, and includes, in the constitutional unit I, both an amide group as a site to exhibit hydrophilicity for interacting with the silica particles and at least either an alkyl group or a hydroxyl group as a site exhibiting hydrophobicity for interacting with the silicon wafer. Therefor, the water-soluble macromolecular compound (component C) is adsorbed suitably to the silicon wafer surface and suppresses the corrosion caused by the nitrogen-containing basic compound, whereby a favorable surface roughness (haze) is achieved and a favorable wettability is developed to suppress adhesion of particles due to the drying of the wafer surface so as to allow reduction of the surface defects (LPD).

In general, under an alkaline condition, both the surfaces of the silica particles and of the wafer are charged negatively, and due to the charge repulsion, the silica particles cannot get close to the wafer and the polishing rate cannot be developed sufficiently. However, by making the water-soluble macromolecular compound (component C) be present, the water-soluble macromolecular compound (component C) is adsorbed onto the surfaces of both of the silica particles and the wafer, and thus the binder effect is developed. As a result, the interaction between the silica particles and the wafer is increased and the polishing by the silica particles proceeds effectively, and thus, the water-soluble macromolecular compound (component C) is considered as contributing to ensuring the rate of polishing the silicon wafer.

Only when the weight average molecular weight of the water-soluble macromolecular compound (component C) is 50,000 or more and 1,500,000 or less and 10 wt% or more of the constitutional unit I is included in the water-soluble macromolecular compound (component C), the water-soluble macromolecular compound (component C) is adsorbed suitably to the silicon wafer surface and to the silica particle surface. Thereby, the storage stability of the polishing liquid composition is improved, and the surface roughness and the surface defects (LPD) are reduced. In addition to that, a favorable polishing rate is ensured. However, the present invention is not limited to these assumptions.

### [Silica particles (component A)]

The polishing liquid composition used in the present invention includes silica particles as a polishing material. Specific examples of the silica particles include colloidal silica, fumed silica and the like. From the viewpoint of improving the surface smoothness of the silicon wafer, colloidal silica is further preferred.

For the use state of the silica particles, slurry is preferred from the viewpoint of operability. In a case where the polishing material included in the polishing liquid composition is colloidal silica, from the viewpoint of preventing the silicon wafer from contamination due to an alkali metal, an alkaline earth metal or the like, the colloidal silica is preferably obtained from a hydrolyzate of alkoxysilane. Silica particles obtained from a hydrolyzate of alkoxysilane can be produced by any conventionally known process.

The average primary particle diameter of the silica particles included in the polishing liquid composition is, from the viewpoint of ensuring a certain polishing rate, preferably 5 nm or more, more preferably 10 nm or more, further preferably 15 nm or more, and even further preferably 30 nm or more.
It is preferably 50 nm or less, more preferably 45 nm or less, and further preferably 40 nm or less from the viewpoint of ensuring the polishing rate and also reducing the surface roughness and the surface defects (LPD). Therefore, taking these viewpoints totally in consideration, the average primary particle diameter of the silica particles is preferably in the range of 5 to 50 nm, more preferably 10 to 45 nm, further preferably 15 to 40 nm, and even further preferably 30 to 40 nm.

In particular, in a case of using colloidal silica for the silica particles, from the viewpoint of ensuring the polishing rate and reducing the surface roughness and the surface defects (LPD), the average primary particle diameter is preferably in the range of 5 to 50 nm, more preferably 10 to 45 nm, further preferably 15 to 40 nm, and even further preferably 30 to 40 nm.

The average primary particle diameter of the silica particles is determined by using a specific surface area S (m²/g) that is calculated by a BET (nitrogen adsorption) method. The specific surface area can be measured for example by the method as described in Examples.

From the viewpoint of ensuring the polishing rate and reducing the surface roughness and the surface defects, the degree of association of the silica particles is preferably 3.0 or less, more preferably in the range of 1.1 to 3.0, and further preferably 1.8 to 2.5, and even further preferably 2.0 to 2.3. It is preferable that the shape of the silica particles is a so-called sphere and a so-called cocoon shape. In a case where the silica particles are colloidal silica, the degree of association is preferably 3.0 or less, more preferably in the range of 1.1 to 3.0, further preferably 1.8 to 2.5, and even further preferably 2.0 to 2.3 from the viewpoint of ensuring the polishing rate and reducing the surface roughness and the surface defects.

The degree of association of the silica particles is a coefficient indicating the shape of the silica particles, and it is calculated by the equation below. The average primary particle diameter is a value measured by a dynamic light scattering method, and it can be measured for example by using the device as described in Examples. Degree of association = average secondary particle diameter / average primary particle diameter

Though there is no particular limitation on the method of preparing the silica particles, for example, the methods described in JP H06(1994)-254383, JP H11(1999)-214338, JP H11(1999)-60232, JP 2005-060217, JP 2005-060219 and the like can be employed.

The content of the silica particles included in the polishing liquid composition is preferably 0.05 wt% or more, more preferably 0.1 wt% or more, and further preferably 0.2 wt% or more, from the viewpoint of ensuring the polishing rate. It is preferably 10 wt% or less, more preferably 7.5 wt% or less, further preferably 5 wt% or less, even further preferably 1 wt% or less, and even further preferably 0.5 wt% or less, from the viewpoint of economic efficiency and improvement of the storage stability of the polishing liquid composition. Therefore, taking these viewpoints totally in consideration, the content of the polishing material is preferably in the range of 0.05 to 10 wt%, more preferably 0.1 to 7.5 wt%, further preferably 0.2 to 5 wt%, further preferably 0.2 to 1 wt%, and even further preferably 0.2 to 0.5 wt%.

### [Nitrogen-containing basic compound (component B)]

From the viewpoint of improving the storage stability of the polishing liquid composition, ensuring the polishing rate and reducing the surface roughness and the surface defects (LPD), the polishing liquid composition contains a water-soluble basic compound. The water-soluble basic compound is at least one kind of nitrogen-containing basic compound selected from an amine compound and an ammonium compound. Here, "water-soluble" indicates having a solubility of 2g/100ml or higher with respect to water, and "water-soluble basic compound" indicates a compound exhibiting basicity when being solved in water.

Examples of at least one kind of nitrogen-containing basic compound selected from an amine compound and an ammonium compound include: ammonia, ammonium hydroxide, ammonium carbonate, ammonium bicarbonate, methylamine, dimethylamine, trimethylamine, ethylamine, diethylamine, triethylamine, monoethanolamine, diethanolamine, triethanolamine, N-methylethanolamine, N-methyl-N,N-diethanolamine, N,N-dimethylethanolamine, N,N-diethylethanolamine, N,N-dibutylethanolamine, N-(β-aminoethyl)ethanolamine, monoisopropanolamine, diisopropanolamine, triisopropanolamine, ethylenediamine, hexamethylenediamine, piperazine hexahydrate, anhydrous piperazine, 1-(2-aminoethyl)piperazine, N-methylpiperazine, diethylenetriamine, and tetramethyl ammonium hydroxide. Two or more of the kinds of these nitrogen-containing basic compounds may be mixed in use. For the nitrogen-containing basic compound that can be included in the polishing liquid composition, ammonia is more preferable from the viewpoint of reducing the surface roughness and the surface defects (LPD), improving the storage stability of the polishing liquid composition, and ensuring the polishing rate.

From the viewpoint of reducing the surface roughness and the surface defects of the silicon wafer, improving the storage stability of the polishing liquid composition and ensuring the polishing rate, the content of the nitrogen-containing basic compound included in the polishing liquid composition is preferably 0.001 wt% or more, more preferably 0.005 wt% or more, further preferably 0.007 wt% or more, even further preferably 0.010 wt% or more, and even further preferably 0.012 wt% or more. It is preferably 1 wt% or less, more preferably 0.5 wt% or less, further preferably 0.1 wt% or less, even further preferably 0.05 wt% or less, even further preferably 0.025 wt% or less, even further preferably 0.018 wt% or less, and even further preferably 0.014 wt% or less, from the viewpoint of reducing the surface roughness and the surface defects of the silicon wafer,. Therefore, taking these viewpoints totally in consideration, the content of the nitrogen-containing basic compound is preferably in the range of 0.001 to 1 wt%, more preferably 0.005 to 0.5 wt%, further preferably 0.007 to 0.1 wt%, even further preferably 0.010 to 0.05 wt%, even further preferably 0.010 to 0.025 wt%, even further preferably 0.010 to 0.018 wt%, even further preferably 0.010 to 0.014 wt%, and even further preferably 0.012 to 0.014 wt%.

### [Water-soluble macromolecular compound (component C)]

From the viewpoint of improving the storage stability of the polishing liquid composition, ensuring the polishing rate, and reducing the surface roughness and the surface defects of a silicon wafer, the polishing liquid composition includes 10 wt% or more of the constitutional unit I represented by the general formula (1) below and contains a water-soluble macromolecular compound (component C) having a weight average molecular weight of 50,000 or more and 1,500,000 or less. In the present invention, "water-soluble" in the term of water-soluble macromolecular compound indicates having a solubility of 2g/100ml or higher with respect to water.

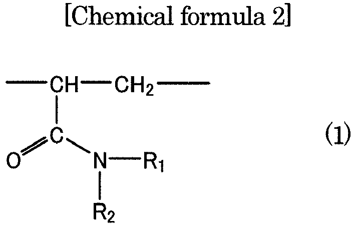

From the viewpoint of improving the storage stability of the polishing liquid composition, ensuring the polishing rate, and reducing the surface roughness and the surface defects of the silicon wafer, in the above general formula (1), R₁ and R₂ each independently represents hydrogen, a C1-C8 alkyl group or a C1-C2 hydroxyalkyl group; more preferably, a hydrogen atom, a C1-C4 alkyl group or a C1-C2 hydroxyalkyl group; and particularly preferably, a hydrogen atom, a methyl group (Me), an ethyl group (Et), an isopropyl group (iPr) or a hydroxyethyl group, although R₁ and R₂ are never both hydrogens. Further, "including 10 wt% or more of the constitutional unit I" indicates that the weight of the constitutional unit I in one molecule of the water-soluble macromolecular compound is 10% or more of the weight average molecular weight (Mw) of the water-soluble macromolecular compound. Here in the present specification, as the content (wt%) of the constitutional unit I in the whole constitutional units for constituting the water-soluble macromolecular compound, depending on the condition to synthesize, it is possible to use a value calculated from the amount of compound (wt%) for introducing the constitutional unit I stocked in a reaction tank, among the compounds for introducing the whole constitutional units stocked in the reaction tank in all of the steps for synthesizing the water-soluble macromolecular compound.

From the viewpoint of improving the storage stability of the polishing liquid composition, ensuring the polishing rate, and reducing the surface roughness and the surface defects of the silicon wafer, in the general formula (1), the constitutional unit I is preferably at least one selected from the group consisting of constitutional units I-I to I-III, i.e., a constitutional unit I-I where both R₁ and R₂ are C1-C4 alkyl groups; a constitutional unit I-II where R₁ is a hydrogen atom and R₂ is a C1-C8 alkyl group; and a constitutional unit I-III where R₁ is a hydrogen atom and R₂ is a C1-C2 hydroxyalkyl group. In the constitutional unit I-I, from the viewpoint of ensuring the polishing rate, preferably both R₁ and R₂ are methyl groups or ethyl groups, and more preferably they are ethyl groups. In the constitutional unit I-II, preferably R₂ is an isopropyl group, from the viewpoint of reducing the surface roughness. Further, in the constitutional units I-III, preferably R₂ is a hydroxyethyl group, from the viewpoint of ensuring the polishing rate and reducing the surface defects.

Examples of the monomer as a supply source for supplying the constitutional unit I represented by the general formula (1) include: N-methylacrylamide, N-ethylacrylamide, N-propylacrylamide, N-isopropylacrylamide (NIPAM), N-butylacrylamide, N-isobutylacrylamide, N-tertiary butylacrylamide, N-heptylacrylamide, N-octylacrylamide, N-tertiary octylacrylamide, N-methylolacrylamide, N-hydroxyethylacrylamide (HEAA), N,N-dimethylacrylamide (DMAA), N,N-diethylacrylamide (DEAA), N,N-dipropylacrylamide, N,N-diisopropylacrylamide, N,N-dibutylacrylamide, N,N-diisobutylacrylamide, N,N-diheptylacrylamide, N,N-dioctylacrylamide, N,N-dimethylolacrylamide, and N,N-dihydroxyethylacrylamide. They can be used singly or as a combination of at least two. Among these monomers, from the viewpoint of reducing the surface roughness and ensuring the polishing rate, N-isopropylacrylamide, N-hydroxyethylacrylamide, N,N-dimethlacrylamide, and N,N-diethylacrylamide are preferred. N-hydroxyethylacrylamide, N,N-diethylacrylamide are more preferred, and, from the viewpoint of reducing the surface defects, N-hydroxyethylacrylamide is even further preferred.

In a case where neither R₁ or R₂ is a C1-C2 hydroxyalkyl group, from the viewpoint of reducing the surface roughness and the surface defects of the silicon wafer, the percentage of the constitutional unit I in the whole constitutional units of the water-soluble macromolecular compound (component C) is 10 wt% or more, preferably 20 wt% or more, and more preferably 40 wt% or more. It is preferably 100 wt% or less, more preferably 90 wt% or less, and further preferably 60 wt% or less from the viewpoint of ensuring the polishing rate. Taking these viewpoints totally in consideration, the percentage of the constitutional unit I in the whole constitutional units of the water-soluble macromolecular compound (component C) is 10 wt% or more, preferably in the range of 10 to 100 wt%, more preferably 20 to 90 wt%, and further preferably 40 to 60 wt%. In a case where either R₁ or R₂ or both of them are C1-C2 hydroxyalkyl group(s), the percentage of the constitutional unit I in the whole constitutional units of the water-soluble macromolecular compound (component C) is 10 wt% or more, preferably in the range of 60 to 100 wt%, more preferably 80 to 100 wt%, and further preferably 90 to 100 wt%, from the viewpoint of reducing the surface roughness and the surface defects of the silicon wafer and ensuring the polishing rate.

In a case where the water-soluble macromolecular compound (component C) includes any other constitutional unit(s) than the constitutional unit I, from the viewpoint of ensuring the polishing rate and reducing the surface roughness and the surface defects, the constitutional unit other than the constitutional unit I is preferably a constitutional unit II (acrylamide (AAm)) represented by a general formula (2) below.

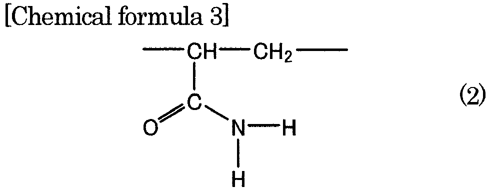

In a case where the water-soluble macromolecular compound (component C) is a copolymer including the constitutional unit I represented by the general formula (1) and a constitutional unit II represented by the general formula (2) described above, from the viewpoint of reducing the surface roughness and the surface defects of the silicon wafer, the percentage of the constitutional unit I in the whole constitutional units is 10 wt% or more, preferably 20 wt% or more, and more preferably 40 wt% or more. Preferably it is 100 wt% or less, more preferably 90 wt% or less, and further preferably 60 wt% or less, from the viewpoint of ensuring the polishing rate. Taking these viewpoints totally in consideration, the percentage of the constitutional unit I in the whole constitutional units is 10 wt% or more, preferably in the range of 10 to 100 wt%, more preferably 20 to 90 wt%, and further preferably 40 to 60 wt%.

Therefore, from the viewpoint of reducing the surface roughness and the surface defects of the silicon wafer and ensuring the polishing rate, a value obtained by dividing the weight of the constitutional unit I by the sum total of the weight of the constitutional unit I and the weight of the constitutional unit II [weight of constitutional unit I / (weight of constitutional unit I + weight of constitutional unit II)] is 0.1 or more, preferably in the range of 0.1 to 1, more preferably 0.2 to 0.9, and further preferably 0.4 to 0.6.

In a case where the water-soluble macromolecular compound (component C) is a copolymer including the constitutional unit I represented by the general formula (1) and a constitutional unit II represented by the general formula (2) described above, from the viewpoint of improving the polishing rate, the percentage of the constitutional unit II in the whole constitutional units is preferably 20 wt% or more, more preferably 30 wt% or more, and further preferably 45 wt% or more. Preferably it is 80 wt% or less, and more preferably 55 wt% or less, from the viewpoint of reducing the surface roughness. Taking these viewpoints totally in consideration, the percentage of the constitutional unit II in the whole constitutional units is preferably in the range of 20 to 80 wt%, more preferably 30 to 80 wt%, and further preferably 45 to 55 wt%.

The water-soluble macromolecular compound (component C) may be a copolymer including any other constitutional unit than the constitutional unit I represented by the general formula (1) and the constitutional unit II represented by the general formula (2). Examples of the monomer component to form such a constitutional unit include acrylic acid, methacrylic acid, methyl acrylate, methyl methacrylate, styrene, vinylpyrrolidone and oxazoline.

In a case where the water-soluble macromolecular compound (component C) is a copolymer including the constitutional unit I represented by the general formula (1) and any other constitutional unit than the constitutional unit I, arrangement of the constitutional unit I and the constitutional unit other than the constitutional unit I in the copolymer may be in a block or at random.

From the viewpoint of reducing the surface roughness of the silicon wafer, the weight average molecular weight of the water-soluble macromolecular compound (component C) is 50,000 or more and 1,500,000 or less. Preferably it is in the range of 50,000 to 900,000, more preferably 50,000 to 700,000, and further preferably 50,000 to 500,000. It is 50,000 or more and 1,500,000 or less, preferably in the range of 80,000 to 1,500,000, more preferably 150,000 to 1,200,000, further preferably 250,000 to 1,000,000, even further preferably 250,000 to 900,000, and even further preferably 300,000 to 700,000, from the viewpoint of reducing the surface defects of the silicon wafer. It is 1,500,000 or less from the viewpoint of storage stability. It is 50,000 or more, preferably 80,000 or more, more preferably 150,000 or more, further preferably 250,000 or more, and even further preferably 300,000 or more, from the viewpoint of ensuring the polishing rate. Therefore, from the viewpoint of reducing the surface roughness and the surface defects of the silicon wafer, from the viewpoint of improving the storage stability, and from the viewpoint of ensuring the polishing rate, the weight average molecular weight of the water-soluble macromolecular compound (component C) is 50,000 or more and 1,500,000 or less, preferably in the range of 80,000 to 1,500,000, more preferably 150,000 to 900,000, and further preferably 300,000 to 700,000. The weight average molecular weight of the water-soluble macromolecular compound is measured by the method as described in Examples described below.

From the viewpoint of reducing surface roughness of the silicon wafer, the content of the water-soluble macromolecular compound (component C) included in the polishing liquid composition is preferably 0.001 wt% or more, more preferably 0.002 wt% or more, further preferably 0.003 wt% or more, and even further preferably 0.008 wt% or more. From the viewpoint of improving the storage stability, the content of the water-soluble macromolecular compound (component C) is preferably 0.8 wt% or less, more preferably 0.5 wt% or less, further preferably 0.1 wt% or less, even further preferably 0.05 wt% or less, and even further preferably 0.02 wt% or less. From the viewpoint of ensuring the polishing rate, the content of the water-soluble macromolecular compound (component C) is preferably 0.8 wt% or less, more preferably 0.5 wt% or less, further preferably 0.1 wt% or less, even further preferably 0.05 wt% or less, even further preferably 0.020 wt% or less, even further preferably 0.016 wt% or less, and even further preferably 0.012 wt% or less. From the viewpoint of reducing the surface defects, the content of the water-soluble macromolecular compound (component C) is preferably in the range of 0.001 to 0.8 wt%, more preferably 0.001 to 0.1 wt%, further preferably 0.002 to 0.050 wt%, even further preferably 0.003 to 0.020 wt%, even further preferably 0.008 to 0.016 wt%, and even further preferably 0.008 to 0.012 wt%. Therefore, from the viewpoint of reducing the surface roughness and the surface defects of the silicon wafer, and from the viewpoint of improving the storage stability and ensuring the polishing rate, the content of the water-soluble macromolecular compound (component C) is preferably in the range of 0.001 to 0.8 wt%, more preferably 0.002 to 0.5 wt%, further preferably 0.002 to 0.1 wt%, even further preferably 0.002 to 0.05 wt%, even further preferably 0.002 to 0.016 wt%, even further preferably 0.003 to 0.016 wt%, even further preferably 0.008 to 0.016 wt%, and even further preferably 0.008 to 0.012 wt%.

In a case where the water-soluble macromolecular compound (component C) is a homopolymer of N-hydroxyethylacrylamide (HEAA), from the viewpoint of reducing the surface roughness and the surface defects (LPD) of the silicon wafer, the mass ratio of the silica particles (component A) to the water-soluble macromolecular compound (component C) included in the polishing liquid composition (mass of silica particles (component A) / mass of water-soluble macromolecular compound (component C)) is preferably 200 or less, more preferably 150 or less, further preferably 100 or less, even further preferably 50 or less, and even further preferably 30 or less. It is preferably 10 or more, more preferably 15 or more, and further preferably 20 or more, from the viewpoint of ensuring the polishing rate and reducing the surface defects (LPD).

### [Aqueous medium (component D)]

Examples of the aqueous medium (component D) included in the polishing liquid composition include water such as ion-exchanged water and ultrapure water, or a mixed medium of water and a solvent. For the solvent, a solvent mixable with water (e.g., alcohols such as ethanol) is preferred. Among them, for the aqueous medium, ion-exchanged water or ultrapure water is preferred, and ultrapure water is further preferred. In a case where the component D is a mixed medium of water and a solvent, the percentage of water with respect to the whole mixed medium as the component D is not limited in particular, but it is preferably 95 wt% or more, more preferably 98 wt% or more, and further preferably substantially 100 wt% from the viewpoint of economic efficiency.

The content of the aqueous medium in the polishing liquid composition is not limited in particular, and it may be the residue of the components A-C and any arbitrary component described below.

The pH of the polishing liquid composition is in the range of 8.0 to 12.0 at 25°C, preferably 9.0 to 11.5, and more preferably 9.5 to 11.0 from the viewpoint of suppressing agglomeration of the silica particles so as to reduce the surface roughness and the surface defects (LPD) of the silicon wafer, from the viewpoint of ensuring the polishing rate, and from the viewpoint of suppressing corrosion of the containers, devices and the like and keeping a favorable handling property. The pH can be adjusted by suitably adding the nitrogen-containing basic compound (component B) and/or a pH regulator as described below. Here, the pH at 25°C can be measured with a pH meter (HM-30G manufactured by DKK-TOA CORPORATION) and is read on the pH meter 1 minute after dipping an electrode into the polishing liquid composition.

### [Arbitrary component]

The polishing liquid composition may further include at least one arbitrary component selected from a water-soluble macromolecular compound other than the component C, a pH regulator, an antiseptic agent, alcohols, a chelating agent, a cationic surfactant, an anionic surfactant, a nonionic surfactant, and an oxidizer, as long as the effects of the present invention are not impaired.

### <Water-soluble macromolecular compound other than component C>

From the viewpoint of reducing the surface roughness, the polishing liquid composition may contain further a water-soluble macromolecular compound (component E) other than the water-soluble macromolecular compound (component C). This water-soluble macromolecular compound (component E) is a macromolecular compound having a hydrophilic group, and from the viewpoint of ensuring the polishing rate and reducing the surface roughness and the surface defects of the silicon wafer, the weight average molecular weight of the water-soluble macromolecular compound (component E) is preferably 500 or more and 250,000 or less. Examples of the homopolymer as a supply source constituting the component E include a monomer having a water-soluble group such as an amide group other than the amide group derived from the constitutional unit I of the component C, a hydroxyl group, a carboxyl group, a carboxylic acid ester group, and a sulfonic acid group. Examples of the water-soluble macromolecular compound (component E) include polyamide, poly(N-acylalkyleneimine), a cellulose derivative, polyvinyl alcohol, and a derivative of polyalkylene oxide such as polyethylene oxide. Two or more kinds of these water-soluble macromolecular compounds may be mixed in use at an arbitrary ratio.

Examples of the polyamide include polyvinyl pyrrolidone, polyacrylamide, and polyoxazoline.

Examples of the poly(N-acylalkyleneimine) include poly(N-acetylethyleneimine), poly(N-propionylethyleneimine), poly(N-caproylethyleneimine), poly(N-benzoylethyleneimine), poly(N-nonadezoylethyleneimine), poly(N-acetylpropyleneimine), and poly(N-butionylethyleneimine).

Examples of the cellulose derivatives include carboxymethyl cellulose, hydroxyethyl cellulose, hydroxyethyl methyl cellulose, hydroxypropyl cellulose, hydroxypropyl methyl cellulose, methyl cellulose, ethyl cellulose, hydroxyethyl ethyl cellulose, and carboxymethyl ethyl cellulose.

Examples of the derivative of polyalkylene oxide include an alkylene oxide adduct of polyhydric alcohol (hereinafter, it may be referred to also as "alcohol AO adduct"). The alcohol AO adduct is a polyhydric alcohol derivative obtained by addition polymerization of polyhydric alcohol with alkylene oxide such as ethylene oxide or propylene oxide.

From the viewpoint of reducing the surface defects and the surface roughness of the silicon wafer, the weight average molecular weight of the alcohol AO adduct is preferably 500 or more and 250,000 or less. In a case where the alcohol AO adduct is an ethylene oxide adduct of polyhydric alcohol, from the viewpoint of reducing the surface defects and the surface roughness of the silicon wafer, the weight average molecular weight is 500 or more, preferably 1000 or more, more preferably 1200 or more, further preferably 2000 or more, and even further preferably 4000 or more. It is 250,000 or less, preferably 220,000 or less, more preferably 180,000 or less, further preferably 50,000 or less, even further preferably 30,000 or less, even further preferably 10,000 or less, and even further preferably 8,000 or less, from the viewpoint of reducing the surface defects and the surface roughness of the silicon wafer and improving the storage stability of the polishing liquid composition.

From the viewpoint of enhancing the adsorption strength of the alcohol AO adduct to the silicon wafer surface and from the viewpoint of reducing the surface defects and the surface roughness of the silicon wafer, the number of hydroxyl groups of the polyhydric alcohol as the raw material of the polyalkylene oxide derivative is preferably 2 or more, and from the viewpoint of ensuring the polishing rate, it is preferably 10 or less, more preferably 8 or less, further preferably 6 or less, and even further preferably 4 or less.

Specific examples of the alcohol AO adduct include an ethylene glycol alkylene oxide adduct, a glycerin alkylene oxide adduct, and a pentaerythritol alkylene oxide adduct. A glycerin alkylene oxide adduct and a pentaerythritol alkylene oxide adduct are preferred in particular since the molecular sizes of these adducts having branched-chains are small and thus it is considered that the rate of adsorption to the silicon wafer surface is great.

From the viewpoint of reducing the surface defects and the surface roughness of the silicon wafer, the alkylene oxide group included in the alcohol AO adduct is preferably at least one alkylene oxide group selected from the group consisting of an oxyethylene group (EO) and an oxypropylene group (PO), and EO is further preferred. In a case where both EO and PO are included, the EO and PO may be arranged in a block or at random.

From the viewpoint of reducing the surface defects and the surface roughness of the silicon wafer, the average number of added moles of EO is preferably 10 or more, more preferably 20 or more, further preferably 50 or more, and even further preferably 100 or more. And it is preferably 5000 or less, more preferably 2000 or less, further preferably 800 or less, and even further preferably 200 or less. The average number of added moles of PO is preferably 10 or more, more preferably 20 or more, and further preferably 50 or more. And it is preferably 5000 or less, more preferably 2000 or less, further preferably 800 or less, and even further preferably 200 or less.

From the viewpoint of reducing the surface defects and the surface roughness of the silicon wafer, the content of the alcohol AO adduct in the polishing liquid composition is preferably 0.00001 mass% or more, more preferably 0.0003 mass% or more, and further preferably 0.0005 mass% or more. It is preferably 0.005 mass% or less, more preferably 0.0020 mass% or less, and further preferably 0.0018 mass% or less, from the viewpoint of ensuring the polishing rate.

From the viewpoint of reducing the surface defects and the surface roughness of the silicon wafer, the mass ratio of the alcohol AO adduct to the silica particles included in the polishing liquid composition (mass of alcohol AO adduct / mass of silica particles) is preferably 0.00004 or more, more preferably 0.0012 or more, and further preferably 0.002 or more. It is preferably 0.02 or less, and more preferably 0.0080 or less, and further preferably 0.0072 or less.

From the viewpoint of reducing the surface defects and the surface roughness of the silicon wafer, the mass ratio of the water-soluble macromolecular compound to the alcohol AO adduct included in the polishing liquid composition (mass of water-soluble macromolecular compound / mass of alcohol AO adduct) is preferably 1 or more, more preferably 3 or more, and further preferably 5 or more. It is preferably 200 or less, more preferably 100 or less, and further preferably 60 or less.

### <pH regulator>

The pH regulator may be, e.g., an acid compound. Examples of the acid compound include inorganic acids such as sulfuric acid, hydrochloric acid, nitric acid, and phosphoric acid and organic acids such as acetic acid, oxalic acid, succinic acid, glycolic acid, malic acid, citric acid, or benzoic acid and the like.

### <Antiseptic agent>

Examples of the antiseptic agent include benzalkonium chloride, benzethonium chloride, 1,2-benzisothiazolin-3-one, (5-chloro-)2-methyl-4-isothiazoline-3-one, hydrogen peroxide, or hypochlorite and the like.

### <Alcohols>

Examples of the alcohols include methanol, ethanol, propanol, butanol, isopropyl alcohol, 2-methyl-2-propanol, ethylene glycol, propylene glycol, polyethylene glycol, and glycerin. The content of the alcohols in the polishing composition is preferably 0.1 to 5 wt%.

### <Chelating agent>

Examples of the chelating agent include ethylenediaminetetraacetic acid, sodium ethylenediaminetetraacetic acid, nitrilotriacetic acid, sodium nitrilotriacetic acid, ammonium nitrilotriacetic acid, hydroxyethylethylenediaminetriacetic acid, sodium hydroxyethylethylenediaminetriacetic acid, triethylenetetraminehexaacetic acid, and sodium triethylenetetraminehexaacetic acid. The content of the chelating agent in the polishing liquid composition is preferably 0.01 to 1 wt%.

### <Cationic surfactant>

Examples of the cationic surfactant include aliphatic amine salt and aliphatic ammonium salt.

### <Anionic surfactant>

Examples of the anionic surfactant include fatty acid soap, carboxylates such as alkyl ether carboxylate, sulfonates such as alkyl benzene sulfonate and alkyl naphthalene sulfonate, sulfates such as fatty alcohol sulfate and alkyl ether sulfate, and phosphates such as alkyl phosphate.

### <Nonionic surfactant>

Examples of nonionic surfactant include: polyethylene glycol types such as polyoxyethylene sorbitan fatty acid ester, polyoxyethylene sorbitol fatty acid ester, polyoxyethylene glycerin fatty acid ester, polyoxyethylene fatty acid ester, polyoxyethylene alkylether, polyoxyethylene alkyl phenyl ether, and polyoxyalkylene (hydrogenated) castor oil; polyhydric alcohol types such as sucrose fatty acid ester, polyglycerin alkylether, polyglyceryl fatty acid ester, and alkyl glycoside; and fatty acid alkanolamide.

### <Oxidizer>

Examples of oxidizer include peroxides such as permanganic acid and peroxo acid, chromic acid, nitric acid, and salts thereof.

The content of each of the components described above is the amount when the polishing composition is being used. However, the polishing liquid composition may be stored and supplied in a concentrated state as long as the storage stability is not impaired. This is preferred because the production and transportation costs can be reduced further. The concentrated liquid may be appropriately diluted with the above-mentioned aqueous medium as needed. The concentration rate is not limited in particular as long as the concentration of the diluted solution can be ensured during the polishing. From the viewpoint of further reducing the production and transportation costs, preferably it is 2 to 50 times, more preferably 10 to 45 times, further preferably 20 to 45 times, and even further preferably 30 to 40 times.

In a case where the polishing liquid composition is the above-mentioned concentrated liquid, the content of the silica particles (component A) in the concentrated liquid is preferably 5 wt% or more, more preferably 7 wt% or more, and further preferably 8 wt% or more from the viewpoint of reducing the production and transportation costs. From the viewpoint of improving the storage stability, the content of the silica particles in the concentrated liquid is preferably 40 wt% or less, more preferably 35 wt% or less, further preferably 30 wt% or less, even further preferably 20 wt% or less, and even further preferably 15 wt% or less. Taking these viewpoints totally in consideration, the content of the silica particles in the concentrated liquid is preferably in the range of 5 to 40 wt%, more preferably 7 to 35 wt%, further preferably 8 to 30 wt%, even further preferably 8 to 20 wt%, and even further preferably 8 to 15 wt%.

In a case where the polishing liquid composition is the above-mentioned concentrated liquid, the content of the water-soluble macromolecular compound (component C) in the concentrated liquid is preferably 0.005 wt% or more, more preferably 0.01 wt% or more, further preferably 0.02 wt% or more, even further preferably 0.05 wt% or more, and even further preferably 0.1 wt% or more, from the viewpoint of reducing the production and transportation costs. From the viewpoint of improving the storage stability, the content of the water-soluble macromolecular compound (component C) in the concentrated liquid is preferably 5 wt% or less, more preferably 3 wt% or less, further preferably 2 wt% or less, and even further preferably 1 wt% or less. Taking these viewpoints totally in consideration, the content of the water-soluble macromolecular compound (component C) in the concentrated liquid is preferably in the range of 0.005 to 5 wt%, more preferably 0.01 to 3 wt%, further preferably 0.02 to 2 wt%, even further preferably 0.05 to 1 wt%, and even further preferably 0.1 to 1 wt%.

In a case where the polishing liquid composition is the above-mentioned concentrated liquid, the content of the nitrogen-containing basic compound (component B) in the concentrated liquid is preferably 0.02 wt% or more, more preferably 0.05 wt% or more, and further preferably 0.1 wt% or more, from the viewpoint of reducing the production and transportation costs. From the viewpoint of improving the storage stability, the content of the nitrogen-containing basic compound (component B) in the concentrated liquid is preferably 5 wt% or less, more preferably 2 wt% or less, and further preferably 1 wt% or less. Therefore, the content of the nitrogen-containing basic compound (component B) in the concentrated liquid is preferably in the range of 0.02 to 5 wt%, more preferably 0.05 to 2 wt%, and further preferably 0.1 to 1 wt%.

In a case where the polishing liquid composition is the above-mentioned concentrated liquid, the pH of the concentrated liquid at 25°C is in the range of 8.0 to 12.0, preferably 9.0 to 11.5, and more preferably 9.5 to 11.0, from the viewpoint of suppressing agglomeration of the silica particles so as to reduce the surface roughness and the surface defects (LPD) of the silicon wafer, from the viewpoint of ensuring the polishing rate, and from the viewpoint of suppressing corrosion of the container, device and the like and keeping a favorable handling property.

Hereinafter, one example of the method of manufacturing the polishing liquid composition will be described.

There is no limitation on the example of the method for manufacturing the polishing liquid composition. For example, the composition can be prepared by mixing silica particles (component A), a nitrogen-containing basic compound (component B), a water-soluble macromolecular compound (component C), an aqueous medium (component D) and any arbitrary component as required.

The silica particles can be dispersed in the aqueous medium using any stirrer such as a homomixer, a homogenizer, an ultrasonic disperser, a wet ball mill, or a bead mill. If coarse particles resulting from the agglomeration or the like of the silica particles are present in the aqueous medium, it is preferable that the coarse particles should be removed by centrifugal separation, filtration with a filter, etc. The silica particles are dispersed in the aqueous medium preferably in the presence of the water-soluble macromolecular compound (component C).

The polishing liquid composition is used for polishing a silicon wafer, for example in a step of polishing a silicon wafer in the process of manufacturing a semiconductor substrate.

The step of polishing a silicon wafer includes a lapping (rough polishing) step and a final polishing step. The lapping step includes planarizing the silicon wafer that has been obtained by slicing a silicon single crystal ingot into thin disks. The final polishing step includes etching the lapped silicon wafer and then mirror-finishing the surfaces of the silicon wafer. It is more preferable that the polishing liquid composition is used in the final polishing step.

In the method for manufacturing the semiconductor substrate or the use for polishing a silicon wafer of the present invention, a dilution step of diluting the polishing liquid composition (concentrated liquid) may be included in advance of the step of polishing the silicon wafer. For the dilution medium, an aqueous medium (component D) may be used.

From the viewpoint of reducing the production and transportation costs and improving the storage stability, the concentrated liquid diluted in the dilution step preferably include the component A in the range of 5 to 40 wt%, the component B in the range of 0.02 to 5 wt%, and the component C in the range of 0.005 to 5 wt%.

### Examples

### <Synthesis of water-soluble macromolecular compound>

Water-soluble macromolecular compounds used in Examples 1-6 and 8-72 below were synthesized in the following manner.

### (Water-soluble macromolecular compound No. 1)

### [Copolymer of NIPAM and AAm, weight ratio of NIPAM to AAm is 80:20, weight average molecular weight: 400000]

Into a 500 ml separable flask provided with a thermometer and a 5 cm crescent impeller of Teflon, 40 g of isopropyl acrylamide (0.35 mol, manufactured by Kohjin Co., Ltd), 10 g of acrylamide (0.14 mol, manufactured by Waco Pure Chemical Industries Ltd.), 75 g of ion-exchanged water, and 0.028 g of 30% hydrogen peroxide (0.25 mmol, manufactured by Waco Pure Chemical Industries Ltd.) were introduced, thereby obtaining a solution of ion-exchanged water including isopropyl acrylamide and acrylamide dissolved. Next, nitrogen was blown into the solution at 50 ml/min. for 30 minutes. Meanwhile, 0.043 g of L-ascorbic acid (initiator, 0.25 mmol, manufactured by Waco Pure Chemical Industries Ltd.) and 24.93 g of ion-exchanged water were mixed in a 50 ml beaker, thereby dissolving the L-ascorbic acid in the ion-exchanged water so as to obtain a L-ascorbic acid solution, into which nitrogen was blown at 50 ml/min. for 30 minutes. Next, into the solution including the isopropyl acrylamide and acrylamide in the 500 ml separable flask, the L-ascorbic acid solution including the blown nitrogen was dropped at 25°C for 30 minutes. Then, the solution was stirred at 200 rpm (peripheral speed: 1.05 m/s) at 25°C for 1 hour. Further, the temperature was raised to 40°C, and the solution was stirred for 1 hour. After adding 100 ml of ion-exchanged water to the solution in the separable flask, the solution was dropped into 4L of acetone (manufactured by Waco Pure Chemical Industries Ltd.) so as to obtain a copolymer (solid) of NIPAM and AAm at a weight ratio of 80:20. The obtained solid was dried at 70°C/1KPa or less, thereby obtaining 42.7 g of semitransparent solid (yield of copolymer of NIPAM and AAm (weight average molecular weight: 400000): 85%).

### (Water-soluble macromolecular compound No. 2)

### [HEAA homopolymer, weight average molecular weight: 400000]

Into a 500 ml separable flask provided with a thermometer and a 5 cm crescent impeller of Teflon, 40 g of hydroxyethyl acrylamide (0.35 mol, manufactured by Kohjin Co., Ltd.), 0.086 g of 2,2'-azobis(2,4-dimethylvaleronitrile (initiator, V-65B, 0.3 mmol, manufactured by Waco Pure Chemical Industries Ltd.), and 160 g of methanol (manufactured by Waco Pure Chemical Industries Ltd.) were introduced. These were stirred and mixed at 200 rpm (peripheral speed: 1.05 m/s) under a nitrogen atmosphere so as to dissolve the hydroxyethyl acrylamide in the methanol. Next, the temperature of the hydroxyethyl acrylamide solution in the separable flask was raised to 50°C, and the solution was stirred at 50°C for 6 hours. Next, the solution was cooled to 30°C, and then dropped into 4L of acetone (manufactured by Waco Pure Chemical Industries Ltd.) so as to obtain a HEAA homopolymer (solid). The obtained solid was dried at 70°C/1KPa or less, thereby obtaining 39.1 g of semitransparent solid (yield of HEAA homopolymer (weight average molecular weight: 400000): 98%).

### (Water-soluble macromolecular compound No. 3)

### [DMAA homopolymer, weight average molecular weight: 50000]

Into a 200ml separable flask provided with a thermometer and a 5 cm crescent impeller of Teflon, 50 g of dimethylacrylamide (0.50 mol, manufactured by Kohjin Co., Ltd.), 40 g of ethanol (manufactured by Kishida Chemical Co., Ltd.) and 40 g of ion-exchanged water were introduced, thereby obtaining a solution of ethanol and ion-exchanged water including dimethyl acrylamide dissolved. Meanwhile, 1.56 g of 2,2'-azobisisobutylamidine hydrochloride (initiator, 5.7 mmol, V-50, manufactured by Waco Pure Chemical Industries Ltd.), 20 g of ion-exchanged water and 20 g of ethanol (manufactured by Kishida Chemical Co., Ltd.) were mixed in a 50 ml beaker so as to obtain a V-50 solution. Next, the V-50 solution was dropped into the above-stated 200 ml separable flask at 25°C for 1 hour, then stirred at 60°C for 2 hours. Further, the temperature of the solution in the separable flask was raised to 70°C and the solution was stirred for 1 hour. After cooling to 30°C, the solution in the separable flask was dropped into 4L of acetone (manufactured by Waco Pure Chemical Industries Ltd.) so as to obtain a DMAA homopolymer (solid). The obtained solid was dried at 70°C/1KPa or less, thereby obtaining 41.0 g of semitransparent solid (yield of the DMAA homopolymer (weight average molecular weight: 50000): 82%).

### (Water-soluble macromolecular compound No. 4)

### [NIPAM homopolymer, weight average molecular weight: 50000]

Synthesis was conducted similarly to the case of the water-soluble macromolecular compound No. 3 except that 50 g of dimethyl acrylamide (0.50 mol, manufactured by Kohjin Co., Ltd.) was replaced by 50 g of isopropyl acrylamide (0.44 mol, manufactured by Kohjin Co., Ltd.), thereby generating a NIPAM homopolymer (solid). The obtained solid was dried at 70°C/lKPa or less, thereby obtaining 38.4 g of semitransparent solid (yield of NIPAM homopolymer (weight average molecular weight: 50000): 77%).

### (Water-soluble macromolecular compound No. 5)

### [DEAA homopolymer, weight average molecular weight: 50000]

Synthesis was conducted similarly to the case of the water-soluble macromolecular compound No. 3 except that 50 g of dimethyl acrylamide (0.50 mol, manufactured by Kohjin Co., Ltd.) was replaced by 50 g of diethyl acrylamide (0.39 mol, manufactured by Kohjin Co., Ltd.), thereby generating a DEAA homopolymer (solid). The obtained solid was dried at 70°C/1KPa or less, thereby obtaining 45.4 g of semitransparent solid (yield of DEAA homopolymer (weight average molecular weight: 50000): 91%).

### (Water-soluble macromolecular compound No. 6)

### [DMAA homopolymer, weight average molecular weight: 400000]

Into a 200 ml beaker, 50 g of dimethyl acrylamide (0.50 mol, manufactured by Kohjin Co., Ltd.), 40 g of methanol (manufactured by Waco Pure Chemical Industries, Ltd.) and 40 g of ion-exchanged water were introduced, and the dimethyl acrylamide was dissolved in the methanol and the ion-exchanged water so as to obtain a dimethyl acrylamide solution. Meanwhile, in a 50 ml beaker, 0.37 g of 2,2'-azobisisobutylamidine hydrochloride (initiator, 1.4 mmol, V-50, manufactured by Waco Pure Chemical Industries, Ltd.), 10 g of methanol and 10 g of ion-exchanged water were introduced, thereby dissolving the V-50 in the methanol and in the ion-exchanged water. The V-50 solution was added to the dimethyl acrylamide solution contained in the 200 ml beaker so as to mix the solutions. Next, into a 500 ml separable flask provided with a thermometer and a 5 cm crescent impeller of Teflon, 15 g of the mixture solution of the V-50 solution and the dimethyl acrylamide solution was added, and the temperature of the mixture solution in the separable flask was raised from 25°C to 60°C while stirring the mixture solution under a nitrogen atmosphere at 200 rpm (peripheral speed: 1.05 m/s). The residue of the mixture solution was dropped into the separable flask for 1 hour, and then, the mixture solution in the separable flask was stirred at 60°C for 2 hours. The temperature of the mixture solution in the separable flask was further raised to 70°C, and the mixture solution was stirred for 1 hour. After cooling to 30°C, the mixture solution in the separable flask was dropped into 4 L of ethyl acetate (manufactured by Waco Pure Chemical Industries, Ltd.) so as to obtain a DMAA homopolymer (solid). The obtained solid was dried at 70°C/1KPa or less, thereby obtaining 43.0 g of semitransparent solid (yield of DMAA homopolymer (weight average molecular weight: 400000): 86%).

### (Water-soluble macromolecular compound No. 8)

### [DEAA homopolymer, weight average molecular weight: 400000]

Synthesis was conducted similarly to the case of the water-soluble macromolecular compound No. 6 except that 50 g of dimethyl acrylamide (0.50 mol, manufactured by Kohjin Co., Ltd.) was replaced by 50 g of diethyl acrylamide (0.39 mol, manufactured by Kohjin Co., Ltd.), thereby generating a DEAA homopolymer (solid). The obtained solid was dried at 70°C/1KPa or less, thereby obtaining 40.0 g of semitransparent solid (yield of DEAA homopolymer (weight average molecular weight: 400000): 80%).

### (Water-soluble macromolecular compound No. 9)

### [Copolymer of NIPAM and AAm, weight ratio of NIPAM to AAm is 80:20, weight average molecular weight: 100000]

Into a 500 ml separable flask provided with a thermometer and a 5 cm crescent impeller of Teflon, 40 g of isopropyl acrylamide (0.35 mol, manufactured by Kohjin Co., Ltd), 10 g of acrylamide (0.14 mol, manufactured by Waco Pure Chemical Industries Ltd.), 14 g of ethanol (manufactured by Kishida Chemical Co., Ltd.), 70 g of ion-exchanged water, and 0.028 g of 30% hydrogen peroxide (0.25 mmol, manufactured by Waco Pure Chemical Industries Ltd.) were introduced, thereby obtaining a solution of ethanol and ion-exchanged water including isopropyl acrylamide and acrylamide dissolved. Next, nitrogen was blown into the solution at 50 ml/min. for 30 minutes. Meanwhile, 0.043 g of L-ascorbic acid (initiator, 0.25 mmol manufactured by Waco Pure Chemical Industries Ltd.) and 24.93 g of ion-exchanged water were mixed in a 50 ml beaker, thereby dissolving the L-ascorbic acid in the ion-exchanged water so as to obtain a L-ascorbic acid solution, into which nitrogen was blown at 50 ml/min. for 30 minutes. Next, the L-ascorbic acid solution including the blown nitrogen was added to the solution of isopropyl acrylamide and acrylamide in the 500 ml separable flask. Then, the solution was stirred at 200 rpm (peripheral speed: 1.05 m/s) at 25°C for 1 hour. Then, 0.028 g of 30% hydrogen peroxide (0.25 mmol, manufactured by Waco Pure Chemical Industries Ltd.) and 0.043 g of L-ascorbic acid (initiator, 0.25 mmol manufactured by Waco Pure Chemical Industries Ltd.) were added thereto and the solution was stirred at 25°C for 2 hours. To the solution in the 500 ml separable flask, 0.1 g of N,N,N',N'-tetramethylenediamine (0.9 mmol, manufactured by Waco Pure Chemical Industries, Ltd.) and 0.2 g of sodium persulfate (0.8 mmol, manufactured by Mitsubishi Gas Chemical Company, Inc.) were added further, and the solution was stirred for 1.5 hours. Further 100 ml of ethanol was added thereto, and then, the solution in the separable flask was dropped into 4L of acetone (manufactured by Waco Pure Chemical Industries Ltd.) so as to obtain a copolymer (solid) of NIPAM and AAm. The obtained solid was dried at 70°C/1KPa or less, thereby obtaining 42.0 g of semitransparent solid (yield of copolymer of NIPAM and AAm (weight average molecular weight: 100000): 84%).

### (Water-soluble macromolecular compound No. 10)

### [Copolymer of NIPAM and AAm, weight ratio of NIPAM to AAm is 80:20, weight average molecular weight: 200000]

Into a 500 ml separable flask provided with a thermometer and a 5 cm crescent impeller of Teflon, 40 g of isopropyl acrylamide (0.35 mol, manufactured by Kohjin Co., Ltd.), 10 g of acrylamide (0.14 mol, manufactured by Waco Pure Chemical Industries, Ltd.), 75 g of ion-exchanged water, and 0.028 g of 30% hydrogen peroxide (0.25 mmol, manufactured by Waco Pure Chemical Industries, Ltd.) were introduced, thereby obtaining a solution of ion-exchanged water including isopropyl acrylamide and acrylamide dissolved. Next, nitrogen was blown into the solution at 50 ml/min. for 30 minutes. Meanwhile, 0.043 g of L-ascorbic acid (initiator, 0.25 mmol, manufactured by Waco Pure Chemical Industries, Ltd.) and 24.93 g of ion-exchanged water were mixed and dissolved in a 50 ml beaker so as to obtain a L-ascorbic acid solution, into which nitrogen was blown at 50 ml/min. for 30 minutes. Then, the L-ascorbic acid solution including the blown nitrogen was added to the solution of isopropyl acrylamide and acrylamide in the 500 ml separable flask, and the solution was stirred at 25°C for 1 hour. Then, 0.06 g of sodium persulfate (0.25 mmol, manufactured by Mitsubishi Gas Chemical Company, Inc.) was added thereto, and the solution was stirred at 40°C for 1 hour. After adding further 100 ml of ion-exchanged water to the solution in the separable flask, the solution in the separable flask was dropped into 4 L of acetone (manufactured by Waco Pure Chemical Industries, Ltd.) so as to obtain a copolymer (solid) of NIPAM and AAm, where the weight ratio of NIPAM to AAm was 80:20. The obtained solid was dried at 70°C/1KPa or less, thereby obtaining 42.7 g of semitransparent solid (yield of copolymer of NIPAM and AAm (weight average molecular weight: 200000) was 85%).

### (Water-soluble macromolecular compound No. 11)

### [Copolymer of NIPAM and AAm, weight ratio of NIPAM to AAm is 80:20, weight average molecular weight: 600000]

Into a 500 ml separable flask provided with a thermometer and a 5 cm crescent impeller of Teflon, 40 g of isopropyl acrylamide (0.35 mol, manufactured by Kohjin Co., Ltd.), 10 g of acrylamide (0.14 mol, manufactured by Waco Pure Chemical Industries, Ltd.), 50 g of ion-exchanged water, 16.67 g of methanol (manufactured by Waco Pure Chemical Industries, Ltd.), and 0.056 g of soda persulfate (0.25 mmol, manufactured by Mitsubishi Gas Chemical Company, Inc.) were introduced, thereby obtaining a solution of methanol and ion-exchanged water including isopropyl acrylamide and acrylamide dissolved. Next, nitrogen was blown into the solution at 50 ml/min. for 30 minutes. Meanwhile, 0.043 g of L-ascorbic acid (initiator, 0.25 mmol, manufactured by Waco Pure Chemical Industries, Ltd.) and 24.93 g of ion-exchanged water were mixed in a 50 ml beaker so as to obtain a L-ascorbic acid solution, into which nitrogen was blown at 50 ml/min. for 30 minutes. Then, the L-ascorbic acid solution including the blown nitrogen was added to the solution of isopropyl acrylamide and acrylamide in the 500 ml separable flask. The temperature of the solution in the separable flask was raised to 40°C while stirring the solution at 200 rpm (peripheral speed: 1.05 m/s) under a nitrogen atmosphere, and then the solution was stirred at 40°C for 2 hours. After adding 100 ml of methanol to the solution in the separable flask, the solution was dropped into 4 L of acetone (manufactured by Waco Pure Chemical Industries, Ltd.) so as to obtain a copolymer (solid) of NIPAM and AAm, where the weight ratio of NIPAM to AAm was 80:20. The obtained solid was dried at 70°C/1KPa or less, thereby obtaining 46.7 g of semitransparent solid (yield of copolymer of NIPAM and AAm (weight average molecular weight: 600000): 93%).

### (Water-soluble macromolecular compound No. 12)

### [Copolymer of NIPAM and AAm, weight ratio of NIPAM to AAm is 80:20, weight average molecular weight: 800000]

Synthesis was conducted similarly to the case of the (Water-soluble macromolecular compound No. 11) except that the use amount of the soda persulfate was changed from 0056 g (0.25 mmol) to 0.024 g (0.1 mmol) and the use amount of L-ascorbic acid was changed from 0.043 g (025 mmol) to 0.017 g (0.1 mmol), and 2-hours stirring at 40°C was replaced by 6-hours stirring at 40°C and then still-standing for 48 hours, thereby obtaining 34.0 g of semitransparent solid (yield of a copolymer of NIPAM and AAm (weight average molecular weight: 800000): 68%).

### (Water-soluble macromolecular compound No. 13)

### [Copolymer of NIPAM and AAm, weight ratio of NIPAM to AAm is 80:20, weight average molecular weight: 1000000]

Synthesis was conducted similarly to the case of the (Water-soluble macromolecular compound No. 11) except that the use amount of the soda persulfate was changed from 0056 g (0.25 mmol) to 0.019 g (0.08 mmol) and the use amount of L-ascorbic acid was changed from 0.043 g (0.25 mmol) to 0.014 g (0.08 mmol), and 2-hours stirring at 40°C was replaced by 6-hours stirring at 40°C and then still-standing for 48 hours, thereby obtaining 31.0 g of semitransparent solid (yield of a copolymer of NIPAM and AAm (weight average molecular weight: 1000000): 62%).

### (Water-soluble macromolecular compound No. 14)

### [HEAA homopolymer, weight average molecular weight: 800000]

Synthesis was conducted similarly to the case of the (Water-soluble macromolecular compound No. 2) except that the use amount of V-65B was changed from 0.086 g (0.3 mmol) to 0.043 g (0.2 mmol), thereby obtaining 37.1 g of semitransparent solid (yield of HEAA homopolymer (weight average molecular weight: 800000): 93%).

### (Water-soluble macromolecular compound No. 15)

### [Copolymer of NIPAM and AAm, weight ratio of NIPAM to AAm is 50:50, weight average molecular weight: 100000]

Synthesis was conducted similarly to the case of the (Water-soluble macromolecular compound No. 9) except that the amount of isopropyl acrylamide was changed from 40 g (0.35 mol) to 25 g (0.22 mol, manufactured by Kohjin Co., Ltd.), and the amount of acrylamide was changed from 10 g (0.14 mol) to 25 g (0.35 mol, manufactured by Waco Pure Chemical Industries, Ltd.), thereby obtaining 42.3 g of semitransparent solid (yield of copolymer of NIPAM and AAm (weight average molecular weight: 100000): 85%).

### (Water-soluble macromolecular compound No. 16)

### [Copolymer of NIPAM and AAm, weight ratio of NIPAM to AAm is 20:80, weight average molecular weight: 100000]

Synthesis was conducted similarly to the case of the (Water-soluble macromolecular compound No. 9) except that the amount of isopropyl acrylamide was changed from 40 g (0.35 mol) to 10 g (0.09 mol, manufactured by Kohjin Co., Ltd.), and the amount of acrylamide was changed from 10 g (0.14 mol) to 40 g (0.56 mol, manufactured by Waco Pure Chemical Industries, Ltd.), thereby obtaining 38.2 g of semitransparent solid (yield of copolymer of NIPAM and AAm (weight average molecular weight: 100000): 76%).

### (Water-soluble macromolecular compound No. 17)

### [Copolymer of HEAA and NIPAM, weight ratio of HEAA to NIPAM is 95:5, weight average molecular weight: 800000]

Synthesis was conducted similarly to the case of the (Water-soluble macromolecular compound No. 2) except that 38 g of hydroxyethyl acrylamide (0.33 mol) and 2 g of isopropyl acrylamide (0.018 mol, manufactured by Kohjin Co., Ltd.) were introduced in place of 40 g of hydroxyethyl acrylamide (0.35 mmol) into a 500 ml separable flask, and that the use amount of V-65B was changed from 0.086 (0.3 mmol) to 0.043 g (0.2 mmol), thereby obtaining 36.0 g of semitransparent solid (yield of copolymer of HEAA and NIPAM (weight average molecular weight: 800000): 90%).

### (Water-soluble macromolecular compound No. 18)

### [Copolymer of HEAA and NIPAM, weight ratio of HEAA to NIPAM is 80:20, weight average molecular weight: 600000]

Synthesis was conducted similarly to the case of the (Water-soluble macromolecular compound No. 2) except that 32 g of hydroxyethyl acrylamide (0.28 mol) and 8 g of isopropyl acrylamide (0.071 mol, manufactured by Kohjin Co., Ltd.) were introduced in place of 40 g of hydroxyethyl acrylamide (0.35 mmol) into a 500 ml separable flask, and that the use amount of V-65B was changed from 0.086 (0.3 mmol) to 0.043 g (0.2 mmol), thereby obtaining 36.0 g of semitransparent solid (yield of copolymer of HEAA and NIPAM (weight average molecular weight: 600000): 90%).

### (Water-soluble macromolecular compound No. 23)

### [Copolymer of NIPAM and AAm, weight ratio of NIPAM to AAm is 80:20, weight average molecular weight: 20000]

Into a 200 ml separable flask provided with a thermometer and a 5 cm crescent impeller of Teflon, 40 g of isopropyl acrylamide (0.35 mol, manufactured by Kohjin Co., Ltd.), 10 g of acrylamide (0.28 mol, manufactured by Waco Pure Chemical Industries, Ltd.), 40 g of ethanol (manufactured by Kishida Chemical Co., Ltd.), and 40 g of ion-exchanged water were introduced, thereby obtaining a solution of ethanol and ion-exchanged water including isopropyl acrylamide and acrylamide dissolved. Meanwhile, 1.56 g of azobisisobutylamidine hydrochloride (initiator, 5.7 mmol, V-50, manufactured by Waco Pure Chemical Industries, Ltd.), 20 g of ion-exchanged water and 20 g of ethanol (manufactured by Kishida Chemical Co., Ltd.) were mixed in a 50 ml beaker so as to obtain a solution of V-50. Next, while stirring the solution of isopropyl acrylamide and acrylamide at 200 rpm (peripheral speed: 1.05 m/s) in the 200 ml separable flask, the temperature of the solution in the flask was raised to 75 °C. The V-50 solution was dropped into the separable flask for 1 hour, and then, the solution in the separable flask was stirred at 75 °C for 2 hours. Further, the temperature of the solution in the separable flask was raised to 85°C and the solution was stirred for 1 hour. After cooling to 30°C, the solution in the separable flask was dropped into 4L of acetone (manufactured by Waco Pure Chemical Industries, Ltd.), thereby generating a copolymer (solid) of NIPAM and AAm. The obtained solid was dried at 70°C/1KPa or less, thereby obtaining 43.0 g of semitransparent solid (yield of copolymer of NIPAM and AAm (weight average molecular weight: 20000): 86%).

### (Water-soluble macromolecular compound No. 24)

### [HEAA homopolymer, weight average molecular weight: 430000]

Synthesis was conducted similarly to the case of the (Water-soluble macromolecular compound No. 2) except that the use amount of V-65B was changed from 0.086 g (0.3 mmol) to 0.080 g (0.28 mmol), thereby obtaining 39.3 g of semitransparent solid (yield of HEAA homopolymer (weight average molecular weight: 430000): 98%).
Water-soluble macromolecular compounds Nos. 7 and 19-22 are detailed below.
(Water-soluble macromolecular compound No. 7)
   NIPAM homopolymer (weight average molecular weight: 400000, manufactured by Kohjin Co., Ltd.)
(Water-soluble macromolecular compound No. 19)
   Polyacrylamide (PAM, weight average molecular weight: 600000-1000000, manufactured by Waco Pure Chemical Industries, Ltd.)
(Water-soluble macromolecular compound No. 20)
   Polyvinyl pyrrolidone (trade name: Polyvinyl pyrrolidone K-90, weight average molecular weight: 360000-400000, manufactured by Waco Pure Chemical Industries, Ltd.)
(Water-soluble macromolecular compound No. 21)
   HEC (trade name; CF-V weight average molecular weight: 800000-1000000, manufactured by Sumitomo Seika Chemicals, Co., Ltd.)
(Water-soluble macromolecular compound No. 22)
   HEC (trade name; CF-W, weight average molecular weight: 1200000-1500000, manufactured by Sumitomo Seika Chemicals, Co., Ltd.)

### <Measurement of weight average molecular weight>

### (1) Weight average molecular weight of water-soluble macromolecular compound

The weight average molecular weight for each of the water-soluble macromolecular compounds Nos. 1-24 was calculated with reference to the peak in chromatogram obtained by applying a gel permeation chromatography (GPC) method under the conditions below.
Instrument: HLC-8320 GPC (manufactured by Tosoh Corporation, detector integral type)
Column: TSKgel α-M+TSKgel α-M (cation, manufactured by Tosoh Corporation)
Eluant: LiBr (50 mmol/L (0.43 wt%)) and CH3COOH (166.7 mmol/L (1.0 wt%)) are added to ethanol/water (=3/7)
Flow rate: 0.6 mL/min
Column temperature: 40°C
Detector: RI detector
Reference material: polyethylene glycol

### (2) Measurement of weight average molecular weight of alkylene oxide adduct of polyhydric alcohol

The weight average molecular weight of each of the alkylene oxide adducts of polyhydric alcohols Nos. 1-10 was calculated with reference to the peak in chromatogram obtained by applying a gel permeation chromatography (GPC) method under the conditions below.

### <Measurement conditions>

Instrument: HLC-8320 GPC (manufactured by Tosoh Corporation, detector integral type)
Column: GMPWXL+GMPWXL (anion)
Eluant: 0.2M phosphoric acid buffer / CH3CN = 9/1
Flow rate: 0.5 ml/min
Column temperature: 40°C
Detector: RI detector
Reference material: polyethylene glycol

### <Average primary particle diameter of polishing material (silica particles)>

The average primary particle diameter (nm) of the polishing material was calculated by the equation below by using a specific surface area S (m²/g) calculated by the BET (nitrogen adsorption) method.
Average primary particle diameter (nm) = 2727/S

The specific surface area of the polishing material was determined in the following manner. After the following "pre-treatment" was performed, a measurement sample of about 0.1 g was accurately weighed in a measuring cell to four decimal places. The measurement sample was dried in an atmosphere at 110°C for 30 minutes immediately before measuring the specific surface area. Then, the specific surface area was measured by the nitrogen adsorption (BET) method using a specific surface area measuring device (Micromeritics Automatic Surface Area Analyzer, FlowSorb III 2305 manufactured by Shimadzu Corporation).

### [Pre-treatment]

(a) The polishing material in the form of slurry was adjusted to pH 2.5 ± 0.1 with a nitric acid aqueous solution.
(b) The polishing material in the form of slurry having an adjusted pH of 2.5 ± 0.1 was put in a petri dish and dried in a hot air dryer at 150°C for 1 hour.
(c) After drying, the resultant sample was pulverized in an agate mortar.
(d) The pulverized sample was allowed to be suspended in ion-exchanged water at 40°C, and this suspension was filtered through a membrane filter with a pore size of 1 µm.
(e) The substances deposited on the filter were washed five times with 20 g of ion-exchanged water (40°C).
(f) The filter to which the substances were attached was put in a petri dish and dried in an atmosphere at 110°C for four hours.
(g) The dried substances (abrasive grains) were taken out so as not to be mixed with filter scraps and pulverized in a mortar, thereby providing a measurement sample.

### <Average secondary particle diameter of polishing material (silica particles)>

The average secondary particle diameter (nm) of the polishing material was determined in the following manner. The polishing material was added to ion-exchanged water so that the concentration of the polishing material was 0.25 wt%. The resultant aqueous solution was poured into a disposable sizing cuvette (made of polystyrene, 10 mm cell) to a height of 10 mm from the bottom, and then was measured by dynamic light scattering (device name: Zetasizer Nano ZS, manufactured by Sysmex Corporation).

### (1) Preparation of polishing liquid composition

As illustrated in Tables 1-3, 5 and 6, silica particles (colloidal silica, average primary particle diameter: 38 nm, average secondary particle diameter: 78 nm, degree of association: 2.1), a water-soluble macromolecular compound, a 28% ammonia water (special grade chemicals manufactured by Kishida Chemical Co., Ltd.) and ion-exchanged water were stirred and mixed to obtain the polishing liquid compositions of Examples 1-13,19-22 and Comparative Examples 1-5 (they are concentrated liquids with pH of 10.6±0.1 at 25°C). In each of the polishing liquid composition (concentrated liquids), the content of the silica particles was 10 wt%, the content of the water-soluble macromolecular compound was 0.4 wt%, and the content of the ammonia was 0.4 wt%. The residue except the silica particles, the water-soluble macromolecular compound and the ammonia is ion-exchanged water.

Furthermore, as illustrated in Table 4, the concentration of the water-soluble macromolecular compound was varied respectively to obtain the polishing liquid compositions of Examples 14-18. In this case, in each of the polishing liquid compositions used for preparing the polishing liquid compositions (concentrated liquids with pH of 10.6±0.1 at 25°C) of Examples 14-18, the content of the silica particles (colloidal silica, average primary particle diameter: 38 nm, average secondary particle diameter: 78 nm, degree of association: 2.1) was 10 wt%, and the content of the ammonia was 0.4 wt%. The residue excepting the silica particles, the water-soluble macromolecular compound and the ammonia is ion-exchanged water. The contents of the water-soluble macromolecular compounds in Table 4 indicate the values after dilution with ion-exchanged water (diluted by 40 times).

Further, as illustrated in Table 7, the content of ammonia was varied to obtain the polishing liquid compositions (concentrated liquids with pH of 10.6±0.1 at 25°C) of Examples 23-27. In this case, in each of the polishing liquid compositions used for preparing the polishing liquid compositions (concentrated liquids) of Examples 23-27, the content of the silica particles (colloidal silica, average primary particle diameter: 38 nm, average secondary particle diameter: 78 nm, degree of association: 2.1) was 10 wt%, and the content of the water-soluble macromolecular compound was 0.4 wt%. The residue except the silica particles, the water-soluble macromolecular compound and the ammonia is ion-exchanged water. The contents of the ammonia and the water-soluble macromolecular compounds in Table 7 indicate the values after dilution with ion-exchanged water (diluted by 40 times).

Further, as illustrated in Table 8, the pH value at 25°C was varied to obtain the polishing liquid compositions of Examples 28-31, and Comparative Examples 6, 7. In this case, in each of the polishing liquid compositions used for preparing the polishing liquid compositions (concentrated liquids) of Examples 28-31 and Comparative Examples 6 and 7, the content of the silica particles (colloidal silica, average primary particle diameter: 38 nm, average secondary particle diameter: 78 nm, degree of association: 2.1) was 10 wt%, and the content of the water-soluble macromolecular compound was 0.4 wt%. The residue except the silica particles, the water-soluble macromolecular compound and the ammonia is ion-exchanged water. The content of the ammonia was determined such that the pH values at the time of diluting the polishing liquid composition (concentrated liquid) by 40 times with the ion-exchanged water would be the values as illustrated in Table 8.

Further, as illustrated in Table 9, polishing liquid compositions of Examples 32-72 were prepared by using the water-soluble macromolecular compound No. 24. For preparation of the polishing liquid compositions of Examples 36-72, an alcohol AO adduct was used. In each of the polishing liquid compositions used for preparing the polishing liquid compositions (concentrated liquids with pH of 10.6±0.1 at 25°C) of Examples 32-72, the content of the silica particles (colloidal silica, average primary particle diameter: 38 nm, average secondary particle diameter: 78 nm, degree of association: 2.1) was 10 wt%, and the content of the ammonia was 0.4 wt%. The residue except the silica particles, the water-soluble macromolecular compound, the ammonia and the alcohol AO adduct is ion-exchanged water. The contents of the water-soluble macromolecular compounds and the alcohol AO adducts in Table 9 indicate the values after the dilution with the ion-exchanged water (diluted by 40 times). After the dilution, the content of the silica particles is 0.25 wt%, and the content of the ammonia is 0.01 wt%. The pH of the polishing liquid composition after the dilution is 10.3±0.2 at 25°C.

The alcohol AO adducts used for preparing the polishing liquid compositions of Examples 36-72 and the details are stated below. The "alcohol as raw material" stated in Table 9 indicates a polyhydric alcohol that provides the source (raw material) of the alcohol AO adduct. "PE", "Gly" and "EG" indicate pentaerythritol, glycerin and ethylene glycol, respectively.

### (No. 1)

EO adduct of pentaerythritol (an average number of added moles of EO = 140, manufactured by Nippon Nyukazai Co., Ltd.)

### (No. 2)

EO adduct of pentaerythritol (an average number of added moles of EO = 20, manufactured by Nippon Nyukazai Co., Ltd.)

### (No. 3)

EO adduct of pentaerythritol (an average number of added moles of EO = 450, manufactured by Nippon Nyukazai Co., Ltd.)

### (No. 4)

EO adduct of glycerin (an average number of added moles of EO = 20, manufactured by Kao Corporation)

### (No. 5)

EO adduct of glycerin (an average number of added moles of EO = 26, manufactured by Kao Corporation)

### (No. 6)

EO adduct of glycerin (an average number of added moles of EO = 120, manufactured by Kao Corporation)

### (No. 7)

EO adduct of ethylene glycol (an average number of added moles of EO = 25, polyethylene glycol, Mw1000 (value in the catalog), Waco first class, manufactured by Waco Pure Chemical Industries Ltd.)

### (No. 8)

EO adduct of ethylene glycol (an average number of added moles of EO = 150, polyethylene glycol, Mw6000 (value in the catalog), Waco first class, manufactured by Waco Pure Chemical Industries Ltd.)

### (No. 9)

EO adduct of ethylene glycol (an average number of added moles of EO = 500, polyethylene glycol, Mw20000 (value in the catalog), Waco first class, manufactured by Waco Pure Chemical Industries Ltd.)

### (No. 10)

EO adduct of ethylene glycol (an average number of added moles of EO = 5000, polyethylene oxide, Mw200000 (value in the catalog), manufactured by Sigma-Aldrich Co., Ltd.)

The polishing liquid compositions (concentrated liquids) of the above-described Examples 1-13, 19-22 and Comparative Examples 1-5 were diluted by 40 times with ion-exchanged water, thereby obtaining polishing liquid compositions of pH 10.6±0.1 at 25°C. In each of the diluted polishing liquid compositions of Examples 1-13, 19-22 and Comparative Examples 1-5, the content of silica particles is 0.25 wt%, the content of the water-soluble macromolecular compound is 0.01 wt%, and the content of the ammonia is 0.01 wt%. In each of the diluted polishing liquid compositions (pH 10.6±0.1 at 25°C) of Examples 14-18, the content of silica particles is 0.25 wt%, the contents of the water-soluble macromolecular compound are 0.0025, 0.0050, 0.0100, 0.0150, and 0.0200 wt%, and the content of ammonia is 0.01 wt%. In each of the diluted polishing liquid compositions (pH 10.6±0.1 at 25°C) of Examples 23-27, the content of silica particles is 0.25 wt%, the content of the water-soluble macromolecular compound is 0.0100 wt%, and the contents of the ammonia are 0.0050, 0.0075, 0.0100, 0.0125, 0.0150 and 0.0200 wt%.

### (2) Polishing method

A polishing liquid composition (concentrated liquid) was diluted by 40 times with ion-exchanged water. The resultant polishing liquid composition was filtered with a filter (compact cartridge filter MCP-LX-C10S manufactured by Advantec Co., Ltd.), and silicon wafers described below (silicon single-sided mirror wafer 200 mm in diameter (conduction type: P, crystal orientation: 100, resistivity: 0.1 Ω·cm or more and less than 100 Ω·cm)) were subjected to a final polishing under the polishing conditions as described below. In advance of the final polishing, the silicon wafers each was roughly polished by use of a commercially available polishing composition. The silicon wafer that has been roughly polished before a final polishing had a surface roughness (haze) of 2.680.

### <Conditions for final polishing>

Polishing machine: a single-sided 8-inches polishing machine GRIND-X SPP600s (manufactured by Okamoto Machine Tool Works, Ltd.)
Polishing pad: suede pad (manufactured by Toray Coatex Co., ASKER hardness: 64, thickness: 1.37 mm, nap length: 450 µm, opening diameter: 60 µm)
Wafer polishing pressure: 100 g/cm²
Number of rotary table revolutions: 60 rpm
Time of polishing: 10 minutes
Polishing composition supply rate: 200 g/cm²
Temperature of polishing composition: 20°C
Carrier rotation rate: 100 rpm

After the final polishing, the silicon wafer was subjected to washing with ozone and washing with dilute hydrofluoric acid as described below. In the washing with ozone, pure water including 20 ppm of ozone was jetted at a flow rate of 1 L/min. for 3 minutes from a nozzle toward the center of a silicon wafer rotating at 600 rpm. At this time, the temperature of the ozone water was set to a room temperature. Next, washing with dilute hydrofluoric acid was carried out. In the washing with dilute hydrofluoric acid, pure water including 0.5% ammonium hydrogen fluoride (special class; Nakalai Tesque, Inc.) was jetted at a flow rate of 1 L/min. for 6 seconds from a nozzle toward the center of the silicon wafer rotating at 600 rpm. The set of one washing with ozone and one washing with dilute hydrofluoric acid was carried out twice, which was followed by a final spin drying. In the spin drying, the silicon wafer was rotated at 1500 rpm.

### <Evaluation of surface roughness (haze) and surface defects (LPD) of silicon wafer surface>

For the surface roughness (haze) and surface defects (LPD) of the washed silicon wafer, the values at the dark field wide oblique incidence channel (DWO) measured by use of Surfscan SP1 (trade name) manufactured by KLA-Tencor Corporation were used. The surface defect (LPD) was measured at the same time of the haze measurement, and the surface defect (LPD) was evaluated by measuring the number of particles having a maximal length of 50 nm or more on the silicon wafer surface. The results are shown in Tables 1-9. The evaluation result of the surface defects (LPD) indicates that the smaller number (number of particles) is preferable.

### <Evaluation of polishing rate>

The polishing rate was evaluated in the following manner. The weight of each silicon wafer before and after polishing was measured by use of a precise balance ("BP-210S" manufactured by Sartorius). The obtained difference in weight was divided by the density and surface area of the silicon wafer and the polishing time so as to calculate the single-side polishing rate per unit time. In Tables 1-9, the single-side polishing rate in a case of using the polishing liquid composition of Comparative Example 1 is set to be "100" while the polishing rates in cases of using any other polishing liquid compositions are indicated as relative values. A larger numerical value indicates a higher polishing rate. When the relative speed is 20 or more with respect to 100 for Comparative Example 1, the productivity is a permissible level in an actual production.

### <Evaluation of storage stability of polishing liquid composition>

100 g of a polishing liquid composition (concentrated liquid) was introduced into a 100 ml screw tube and sealed to check the storage stability. The concentrated liquid was stored in a 23°C chamber. The evaluation is performed as visual observation, and the results were classified into A to C.
A: No agglomerate was formed, no separation occurred, and the dispersion stability was maintained even 7 days after the preparation of the concentrated liquid.
B: An agglomerate was formed and a separation occurred 2 to 7 days after the preparation.
C: An agglomerate was formed and a separation occurred 1 day after the preparation.

**[Table 1]**

| | Water-soluble macromolecular compound | | | | Surface roughness (Haze) | Storage stability | Polishing rate (Relative value) | Surface defects (LPD) |
|---|---|---|---|---|---|---|---|---|
| | No. | Composition-Type | Functional group^{*2)} | Weight average molecular weight | | | | |
| Ex. 1 | 1 | NIPAM/AAm = 80/20^{*1)} | R₁=H, R₂=*i*Pr | 400000 | 0.007 | A | 174 | 101 |
| Ex. 2 | 2 | HEAA=100^{*1)} | R₁=H, R₂=C₂H₅OH | 400000 | 0.007 | A | 135 | 89 |
| Com.Ex.1 | 19 | PAM | | 600000∼1000000 | 0.039 | A | 100 | 682 |
| Com.Ex.2 | 20 | PVP | | 360000∼400000 | 0.033 | A | 148 | 573 |
| Ccm.Ex.3 | 21 | HEC | | 800000∼1000000 | 0.007 | C | 185 | 158 |
| Com.Ex.4 | 22 | HEC | | 1200000∼1500000 | 0.007 | C | 217 | 192 |

| | | | | | | | | |
|---|---|---|---|---|---|---|---|---|
| *1) NIPAM/AAm = 80/20 indicates that the weight ratio of constitutional unit I derived from NIPAM to constitutional unit II derived from AAm is 80:20. HEAA=100 indicates a homopolymer of HEAA. Hereinafter, in Tables 2-9, compositions and types of water-soluble macromolecular compounds are described in accordance with the same rule. *2) *i*Pr indicates an isopropyl group, which holds true also in Tables 2-9. Note) In Tables 1-9, Ex. and Com.Ex. indicate respectively Example and Comparative Example. | | | | | | | | |

**[Table 2]**

| | Water-soluble macromolecular compound | | | | Surface roughness (Haze) | Storage stability | Polishing rate (relative value) | Surface (LPD) |
|---|---|---|---|---|---|---|---|---|
| | No. | Composition·Type | Functional group^{*1)} | Weight average molecular weight | | | | |
| Ex.3 | 3 | DMAA=100 | Ri=Me, R₂=Me | 50000 | 0.010 | A | 98 | 278 |
| Ex.4 | 4 | NIPAM=100 | R₁=H, R₂=*i*Pr | 50000 | 0.007 | A | 20 | 257 |
| Ex.5 | 5 | DEAA=100 | R₁=Et, R₂=Et | 50000 | 0.009 | A | 217 | 194 |
| Ex.6 | 6 | DMAA=100 | R₁=Me, R₂=Me | 400000 | 0.010 | A | 157 | 223 |
| Ex.7 | 7 | NIPAM=100 | R₁=H, R₂=*i*Pr | 400000 | 0.007 | A | 43 | 177 |
| Ex.8 | 8 | DEAA=100 | R₁=Et, R₂=Et | 400000 | 0.007 | A | 217 | 168 |
| Ex.2 | 2 | HEAA=100 | R₁=H, R₂=C₂H₅OH | 400000 | 0.007 | A | 135 | 89 |

| | | | | | | | | |
|---|---|---|---|---|---|---|---|---|
| *1) Me and Et indicate respectively a methyl group and an ethyl group, which holds true also in Tables 3-9. | | | | | | | | |

As illustrated in Table 1 and Table 2, the polishing liquid compositions of Examples 1-8 each exhibited a favorable storage stability (before dilution) in comparison with the polishing liquid compositions of Comparative Examples 3-4 each including HEC as the water-soluble macromolecular compound. And, when the polishing liquid compositions of Examples 1-8 were used, the surface roughness (haze) and the surface defects (LPD) of the polished silicon wafer were reduced remarkably and favorably in comparison with the case of using the polishing liquid compositions of Comparative Examples 1, 2.

**[Table 3]**

| | Water-soluble mocromolecular compound | | | | Surface roughness (Haze) | Storage stability | Polishing rate (Relative value) | Surface defects (LPD) |
|---|---|---|---|---|---|---|---|---|
| | No. | Composition-Type | Functional group | Weight average molecular weight | | | | |
| Ex.9 | 9 | NIPAM/AAm= 80/20 | R₁=H, R₂=*i*Pr | 100000 | 0.007 | A | 41 | 202 |
| Ex.10 | 10 | NIPAM/AAm= 80/20 | R₁=H, R₂=*i*Pr | 200000 | 0.007 | A | 65 | 172 |
| Ex.1 | 1 | NIPAM/AAm= 80/20 | R₁=H, R₂=*i*Pr | 400000 | 0.007 | A | 174 | 101 |
| Ex.11 | 11 | NIPAM/AAm= 80/20 | R₁=H, R₂=*i*Pr | 600000 | 0.013 | A | 207 | 122 |
| Ex.12 | 12 | NIPAM/AAm= 80/20 | R₁=H, R₂=*i*Pr | 800000 | 0.017 | A | 224 | 147 |
| Ex.13 | 13 | NIPAM/AAm= 80/20 | R₁=H, R₂=*i*Pr | 1000000 | 0.024 | A | 239 | 157 |
| Com.Ex.5 | 23 | NIPAM/AAm= 80/20 | R₁=H, R₂=*i*Pr | 20000 | 0.038 | A | 7 | 427 |

As illustrated in Table 3, in Comparative Example 5 where the weight average molecular weight of the water-soluble macromolecular compound is smaller than 50000, the surface roughness (haze) was noticeable, the polishing rate was decreased and there were many surface defects. On the other hand, in Examples 1 and 11-13 where the weight average molecular weights of the water-soluble macromolecular compounds were 400000 to 1000000, the surface roughness was reduced and at the same time the polishing rate was ensured, the storage stability was favorable, and the effect of reducing the surface defects was high.

**[Table 4]**

| | Water-soluble macromolecular compound | | | | Surface roughness (Haze) | Storage stability | Polishing rate (Relative value) | Surface defects (LPD) |
|---|---|---|---|---|---|---|---|---|
| | No. | Composition-Type | Content (wt%)^{*1)} | Weight average molecular weight | | | | |
| Ex.14 | 14 | HEAA=100 | 0.0025 | 800000 | 0.030 | A | 220 | 202 |
| Ex.15 | 14 | HEAA=100 | 0.0050 | 800000 | 0.024 | A | 250 | 139 |
| Ex.16 | 14 | HEAA=100 | 0.0100 | 800000 | 0.007 | A | 213 | 84 |
| Ex.17 | 14 | HEAA=100 | 0.0150 | 800000 | 0.007 | A | 148 | 103 |
| Ex.18 | 14 | HEAA=100 | 0.0200 | 800000 | 0.007 | A | 43 | 159 |

| | | | | | | | | |
|---|---|---|---|---|---|---|---|---|
| *1) Content of water-soluble macromolecular compound (wt%) is the concentration in use of a polishing composition (the concentrated liquid is diluted by 40 times). | | | | | | | | |

As illustrated in Table 4, even when the contents of the water-soluble macromolecular compounds were as extremely low as 0.0025 to 0.0200 wt%, the surface roughness (haze) and the surface defects (LPD) were reduced and at the same time the polishing rate was ensured, and the storage stability was favorable.

**[Table 5]**

| | Water-soluble macromolecular compound | | | | Surface roughness (Haze) | Storage stability | Polishing rate (Relative value) | Surface defects (LPD) |
|---|---|---|---|---|---|---|---|---|
| | No. | Composition-Type | Functional group | Weight average molecular weight | | | | |
| Ex.4 | 4 | NIPAM/AAm = 100/0 | R₁=H, R₂=iPr | 50000 | 0.007 | A | 20 | 257 |
| Ex.7 | 7 | NIPAM/AAm = 100/0 | R₁=H, R₂=iPr | 400000 | 0.007 | A | 43 | 177 |
| Ex.9 | 9 | NIPAM/AAm = 80/20 | R₁=H, R₂=iPr | 100000 | 0.007 | A | 41 | 202 |
| Ex.19 | 15 | NIPAM/AAm = 50/50 | R₁=H, R₂=iPr | 100000 | 0.010 | A | 80 | 175 |
| Ex.20 | 16 | NIPAM/AAm = 20/80 | R₁=H, R₂=iPr | 100000 | 0.012 | A | 117 | 216 |
| Com.Ex.1 | 19 | NIPAM/AAm = 0/100 | | 600000∼1000000 | 0.039 | A | 100 | 682 |

As illustrated in Table 5, when the water-soluble macromolecular compound included the constitutional unit II represented by the general formula (2), and in particular when the content was in the range of 50 to 80 wt%, the polishing rate was improved.

**[Table 6]**

| | Water-soluble macromolecular compound | | | | Surface roughness (Haze) | Storage stability | Polishing rate (Relative value) | Surface defects (LPD) |
|---|---|---|---|---|---|---|---|---|
| | No. | Composition-Type | Functional group | Weight average molecular weight | | | | |
| Ex.2 | 2 | HEAA/NIPAM = 100/0 | R₁=H, R₂=C₂H₅OH | 400000 | 0.007 | A | 135 | 89 |
| Ex.16 | 14 | HEAA/NIPAM = 100/0 | R₁=H, R₂=C₂H₅OH | 800000 | 0.007 | A | 213 | 84 |
| Ex.21 | 17 | HEA/NIPAM = 95/5 | R₁=H, R₂=C₂H₅OH | 800000 | 0.006 | A | 185 | 95 |
| | | | R₁=H, R₂=iPr | | | | | |
| Ex.22 | 18 | HEAA/NIPAM = 80/20 | R₁=H, R₂=C₂H₅OH | 600000 | 0.006 | A | 148 | 102 |
| | | | R₁=H, R₂=iPr | | | | | |
| Ex.7 | 7 | HEAM/NIPAM = 0/100 | R₁=H, R₂=iPr | 400000 | 0.007 | A | 43 | 177 |

As illustrated in Table 6, when the constitutional unit I of the water-soluble macromolecular compound includes a hydroxyalkyl group, the surface roughness is reduced and at the same time the polishing rate is ensured, the storage stability is favorable, and the effect of reducing the surface defects is high. In particular, a hydroxyl group is considered to contribute to improvement of the polishing rate.

**[Table 7**

| | Water-soluble macromolecular compound | | | NH₃ content (wt%) | Surface roughness (Haze) | Storage stability | Polishing rate (Relative value) | Surface defects (LPD) |
|---|---|---|---|---|---|---|---|---|
| | No. | Type-content(wt%)^{*1)} | Weight average molecular weight | | | | | |
| Ex.23 | 14 | HEAA=100 - 0.0100 | 800000 | 0.0050 | 0.006 | A | 153 | 149 |
| Ex.24 | 14 | HEAA=100 - 0.0100 | 800000 | 0.0075 | 0.006 | A | 180 | 96 |
| Ex.16 | 14 | HEAA=100 - 0.0100 | 800000 | 0.0100 | 0.007 | A | 213 | 84 |
| Ex.25 | 14 | HEAA=100 - 0.0100 | 800000 | 0.0125 | 0.007 | A | 284 | 72 |
| Ex.26 | 14 | HEAA=100 - 0.0100 | 800000 | 0.0150 | 0.008 | A | 321 | 132 |
| Ex.27 | 14 | HEAA=100 - 0.0100 | 800000 | 0.0200 | 0.008 | A | 325 | 155 |

| | | | | | | | | |
|---|---|---|---|---|---|---|---|---|
| *1) Content (wt%) is the concentration in use of a polishing composition (a concentrated liquid is diluted by 40 times). | | | | | | | | |

As illustrated in Table 7, when the nitrogen-containing basic compound was ammonia and the content was 0.0050 to 0.0200 wt%, the effect of reducing the surface roughness and the surface defects was high and the polishing rate was improved.

**[Table 8]**

| | Water-soluble macromolecular compound | | | pH(25°C) | | Surface roughness (Haze) | Storage stability | Polishing rate (Relative value) | Surface defects (LPD) |
|---|---|---|---|---|---|---|---|---|---|
| | No. | Type-content(wt%)^{*1)} | Weight average molecular weight | Before dilution | After dilution | | | | |
| Com.Ex.6 | 14 | HEAA=100 - 0.0100 | 800000 | 7.4 | 7.3 | 0.022 | C | 65 | 754 |
| Ex.28 | 14 | HEAA=100 - 0.0100 | 800000 | 8.6 | 8.5 | 0.016 | B | 110 | 540 |
| Ex.29 | 14 | HEAA=100 - 0.0100 | 800000 | 9.6 | 9.5 | 0.007 | A | 185 | 88 |
| Ex.30 | 14 | HEAA=100 - 0.0100 | 800000 | 10.6 | 10.5 | 0.007 | A | 284 | 72 |
| Ex.31 | 14 | HEAA=100 - 0.0100 | 800000 | 11.6 | 11.5 | 0.008 | A | 310 | 75 |
| Com.Ex.7 | 14 | HEAA=100 - 0.0100 | 800000 | 12.6 | 12.5 | 0.013 | A | 295 | 80 |

| | | | | | | | | | |
|---|---|---|---|---|---|---|---|---|---|
| *1) Content (wt%) is the concentration in use of a polishing composition (a concentrated liquid is diluted by 40 times). | | | | | | | | | |

As illustrated in Table 8, when the pH of the polishing liquid composition of the present invention at 25°C is less than 8, the silica particles agglomerate to degrade the surface roughness and the surface defects of the silicon wafer. In Comparative Example 7 where the pH of the polishing liquid composition at 25°C is greater than 12.0, the storage stability of the polishing liquid composition was favorable, but problems occurred. Namely, the device, the container or the like is degraded, and problems in handling (e.g., a high jeopardy to human bodies) occur. When the pH of the polishing liquid composition at 25°C is 8.0 or more, in particularly, 9.0 or more, suppression of agglomeration of silica particles is remarkable, and thus the storage stability of the polishing liquid composition is improved, and furthermore, the effect of reducing the surface roughness and the surface defects of the silicon wafer is high. The evaluation of the storage stability was conducted with respect to a polishing liquid composition before dilution by 40 times. If the storage stability of the polishing liquid composition in a concentrated liquid state is favorable, similarly the storage stability of the diluted polishing liquid composition is favorable as long as the pH at 25°C is 8.0 to 12.0, preferably 9.0 to 11.5, and more preferably 9.5 to 11.0.

**[Table 9]**

| | | Water-soluble macromolecular compound | | | | Alcohol AO adduct | | | | | | a/b^{*2)} | Evaluation | | | |
|---|---|---|---|---|---|---|---|---|---|---|---|---|---|---|---|---|
| | | No. | *3) | *4) | *5) | No. | *6) | *7) | *8) | *9) | *10) | | *11) | *12) | *13) | *14) |
| | 32 | | HEAA=100 | 430000 | 0.0025 | - | - | - | | | - | - | A | 167 | 0.015 | 176 |
| | 33 | | | | 0.005 | - | - | - | | | - | - | A | 213 | 0.011 | 179 |
| | 34 | | | | 0.0075 | - | - | - | | | - | - | A | 182 | 0.009 | 167 |
| | 35 | | | | 0.01 | - | - | - | | | - | - | A | 150 | 0.009 | 165 |
| | 36 | | HEAA=100 | 430000 | 0.0025 | 1 | PE | 6000 | OH | 140 | 0.0012 | 2.1 | A | 143 | 0.007 | 84 |
| | 37 | | | | 0.005 | | | | | | 0.0012 | 42 | A | 187 | 0.004 | 80 |
| | 38 | | | | 0.0075 | | | | | | 0.0012 | 6.3 | A | 166 | 0.003 | 36 |
| | 39 | | | | 0.01 | | | | | | 0.0012 | 83 | A | 133 | 0.003 | 27 |
| | 40 | | | | 0.02 | | | | | | 0.0012 | 16.7 | A | 120 | 0.003 | 47 |
| | 41 | | | | 0.03 | | | | | | 0.0012 | 25.0 | A | 108 | 0.004 | 52 |
| | 42 | | | | 0.01 | | | | | | 0.0001 | 100.0 | A | 148 | 0.007 | 89 |
| | 43 | | | | 0.01 | | | | | | 0.0002 | 50.0 | A | 145 | 0.007 | 87 |
| | 44 | | | | 0.01 | | | | | | 0.0004 | 25.0 | A | 142 | 0.005 | 55 |
| | 45 | | HEAA=100 | 430000 | 0.01 | 1 | PE | 6000 | OH | 140 | 0.0006 | 16.7 | A | 140 | 0.005 | 54 |
| | 46 | | | | 0.01 | | | | | | 0.0008 | 12.5 | A | 135 | 0.003 | 47 |
| | 47 | | | | 0.01 | | | | | | 0.0012 | 8.3 | A | 133 | 0.003 | 27 |
| | 48 | | | | 0.01 | | | | | | 0.0015 | 6.7 | A | 130 | 0.003 | 23 |
| | 49 | | | | 0.01 | 1 | | 6000 | OH | 140 | 0.0018 | 5.6 | A | 125 | 0.007 | 78 |
| | 50 | | | | 0.01 | 2 | | 1000 | OH | 20 | 0.0002 | 50.0 | A | 125 | 0.004 | 65 |
| | 51 | | HEAA=100 | 430000 | 0.01 | 1 | PE | 6000 | OH | 140 | 0.0004 | 25.0 | A | 142 | 0.005 | 55 |
| Ex. | 52 | 24 | | | 0.01 | 3 | | 20000 | OH | 450 | 0.0004 | 25.0 | A | 148 | 0.005 | 42 |
| | 53 | | | | 0.01 | | | 20000 | OH | | 0.0008 | 12.5 | A | 145 | 0.005 | 152 |
| | 54 | | | | 0.01 | | | 20000 | OH | | 0.0012 | 83 | A | 133 | 0.005 | 118 |
| | 55 | | | | 0.01 | 4 | | 1000 | OH | 20 | 0.0001 | 100.0 | A | 120 | 0.004 | 95 |
| | 56 | | | | 0.01 | | | 1000 | OH | | 0.0002 | 50.0 | A | 110 | 0.005 | 50 |
| | 57 | | | | 0.01 | 5 | | 1300 | OH | 26 | 0.0001 | 100.0 | A | 122 | 0.003 | 88 |
| | 58 | | HEAA=100 | 430000 | 0.01 | | Gly | 1300 | OH | | 0.0002 | 50.0 | A | 113 | 0.005 | 42 |
| | 59 | | | | 0.01 | 6 | | 6000 | OH | 120 | 0.0004 | 25.0 | A | 138 | 0.006 | 80 |
| | 60 | | | | 0.01 | | | 6000 | OH | | 0.0008 | 12.5 | A | 131 | 0.004 | 78 |
| | 61 | | | | 0.01 | | | 6000 | OH | | 0.0012 | 8.3 | A | 127 | 0.003 | 42 |
| | 62 | | | | 0.01 | | | 6000 | OH | | 0.0016 | 63 | A | 122 | 0.003 | 45 |
| | 63 | | | | 0.01 | 7 | | 1000 | OH | 25 | 0.0001 | 100.0 | A | 117 | 0.004 | 78 |
| | 64 | | | | 0.01 | | | 1000 | OH | | 0.0002 | 50.0 | A | 106 | 0.004 | 53 |
| | 65 | | | | 0.01 | 8 | | 6000 | OH | 150 | 0.0004 | 25.0 | A | 129 | 0.006 | 64 |
| | 66 | | | | 0.01 | | | 6000 | OH | | 0.0008 | 12.5 | A | 121 | 0.004 | 33 |
| | 67 | | HEAA=100 | 430000 | 0.01 | | EG | 6000 | OH | | 0.0012 | 8.3 | A | 115 | 0.003 | 37 |
| | 68 | | | | 0.01 | 9 | | 20000 | OH | 500 | 0.0004 | 25.0 | A | 140 | 0.004 | 103 |
| | 69 | | | | 0.01 | | | 20000 | OH | | 0.0008 | 125 | A | 132 | 0.003 | 43 |
| | 70 | | | | 0.01 | | | 20000 | OH | | 0.0012 | 8.3 | A | 125 | 0.003 | 67 |
| | 71 | | | | 0.01 | 10 | | 200000 | OH | 5000 | 0.0004 | 25.0 | A | 148 | 0.007 | 65 |
| | 72 | | | | 0.01 | | | 200000 | OH | | 0.0008 | 12.5 | A | 146 | 0.005 | 72 |

| | | | | | | | | | | | | | | | | |
|---|---|---|---|---|---|---|---|---|---|---|---|---|---|---|---|---|
| *1) Content (wt%) in this table is the concentration in use of a polishing composition (a concentrated liquid is diluted by 40 times). *2) a/b is the mass ratio of a water-soluble macromolecular compound to an alcohol AO adduct included in a polishing liquid composition (mass of water-soluble macromolecular compound / mass of alcohol AO adduct) *3) Composition•Type *4) Weight average molecular weight *5) Content a (wt%) *6) Alcohol as raw material *7) Weight average molecular weight *8) Terminal *9) Number of added moles of EO *10) Content b (wt%) *11) Storage stability *12) Polishing rate (relative value) *13) Surface roughness (haze) *14) Surface defects (LPD) | | | | | | | | | | | | | | | | |

As illustrated in Table 9, when a polyhydric alcohol alkyl oxide adduct is included in a polishing liquid composition of the present invention, the effect of reducing the surface roughness and the surface defects of the silicon wafer is improved remarkably.

### Industrial Applicability

By using a polishing liquid composition in the method and the use according to the present invention, it is possible to reduce the surface roughness (haze) and the surface defects (LPD) of a silicon wafer while ensuring the polishing rate to keep a favorable productivity. Further, the polishing liquid composition is excellent in a storage stability. Therefore, the polishing liquid composition is useful as a polishing liquid composition to be used in a process of manufacturing various semiconductor substrates, and in particular, it is useful as a polishing liquid composition for a final polishing of a silicon wafer.

## Claims

1. A method for manufacturing a semiconductor substrate, comprising a step of polishing a silicon wafer surface by using a polishing liquid composition for a silicon wafer, comprising:
silica particles (component A);
at least one nitrogen-containing basic compound (component B) selected from the group consisting of an amine compound and an ammonium compound; and
a water-soluble macromolecular compound (component C) comprising 10 wt% or more of a constitutional unit I represented by a general formula (1) below and having a weight average molecular weight of 50,000 or more and 1, 500,000 or less, and
having pH in the range of 8.0 to 12.0 at 25°C, 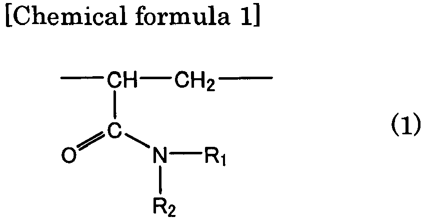 in the above general formula (1), R₁ and R₂ each independently represents a hydrogen, a C1-C8 alkyl group or a C1-C2 hydroxyalkyl group, where R₁ and R₂ are never both hydrogens.

2. The method for manufacturing a semiconductor substrate according to claim 1, wherein the content of the component C in the polishing liquid composition for a silicon wafer is in the range of 0.002 to 0.050 wt%.

3. The method for manufacturing a semiconductor substrate according to claim 1 or 2, wherein in the general formula (1), the constitutional unit I comprises at least one constitutional unit selected from the group consisting of a constitutional unit I-I where both of R₁ and R₂ are C1-C4 alkyl groups, a constitutional unit I-II where R₁ is a hydrogen atom and R₂ is a C1-C8 alkyl group, and a constitutional unit I-III where R₁ is a hydrogen atom and R₂ is a C1-C2 hydroxyalkyl group.

4. The method for manufacturing a semiconductor substrate according to any one of claims 1 to 3, wherein the constitutional unit I is a constitutional unit derived from at least one monomer selected from the group consisting of N-isopropylacrylamide, N-hydroxyethylacrylamide, N,N-dimethylacrylamide, and N,N-diethylacrylamide.

5. The method for manufacturing a semiconductor substrate according to any one of claims 1 to 4, wherein the component C further comprises a constitutional unit II represented by a general formula (2) below, and a value obtained by dividing the weight of the constitutional unit I by the sum total of the weight of the constitutional unit I and the weight of the constitutional unit II [weight of constitutional unit I / (weight of constitutional unit I + weight of constitutional unit II)] is in the range of 0.1 to 1,

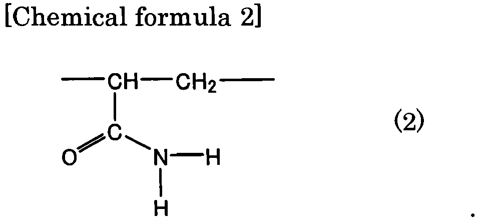

6. The method for manufacturing a semiconductor substrate according to any one of claims 1 to 5, wherein the silica particles have an average primary particle diameter in the range of 5 to 50 nm.

7. The method for manufacturing a semiconductor substrate according to any one of claims 1 to 6, wherein the silica particles are colloidal silica.

8. The method for manufacturing a semiconductor substrate according to any one of claims 1 to 7, further comprising an alkylene oxide adduct of a polyhydric alcohol.

9. The method for manufacturing a semiconductor substrate according to any one of claims 1 to 8, wherein the polishing liquid composition contains 0.05 to 0.5 wt% of the component A.

10. The method for manufacturing a semiconductor substrate according to any one of claims 1 to 9, comprising a step of diluting a concentrated liquid before the polishing step so as to obtain the polishing liquid composition for a silicon wafer.

11. The method for manufacturing a semiconductor substrate according to claim 10, wherein the concentrated liquid contains 5 to 40 wt% of the component A, 0.02 to 5 wt% of the component B and 0.005 to 5 wt% of the component C.

12. Use of the polishing liquid composition for a silicon wafer for polishing a silicon wafer surface, wherein the polishing liquid composition comprises:
silica particles (component A);
at least one nitrogen-containing basic compound (component B) selected from the group consisting of an amine compound and an ammonium compound; and
a water-soluble macromolecular compound (component C) comprising 10 wt% or more of a constitutional unit I represented by a general formula (1) below and having a weight average molecular weight of 50,000 or more and 1, 500,000 or less, and
having pH in the range of 8.0 to 12.0 at 25°C, 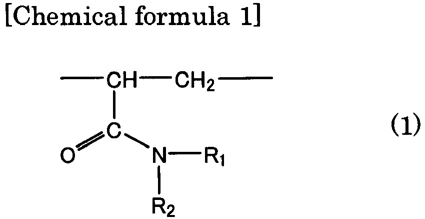 in the above general formula (1), R₁ and R₂ each independently represents a hydrogen, a C1-C8 alkyl group or a C1-C2 hydroxyalkyl group, where R₁ and R₂ are never both hydrogens.

## Patentansprüche

1. Verfahren zur Herstellung eines Halbleitersubstrats, umfassend einen Sc German claim translation hritt des Polierens einer Siliziumwaferoberfläche unter Verwendung einer flüssigen Polierzusammensetzung für einen Siliziumwafer, umfassend:
Siliziumdioxidpartikel (Komponente A);
mindestens eine stickstoffhaltige basische Verbindung (Komponente B) ausgewählt aus der Gruppe bestehend aus einer Aminverbindung und einer Ammoniumverbindung; und
eine wasserlösliche, makromolekulare Verbindung (Komponente C), die 10 Gew.-% oder mehr einer Struktureinheit I, dargestellt durch die allgemeine Formel (1) unten, umfasst und ein gewichtsgemitteltes Molekulargewicht von 50.000 oder mehr und 1.500.000 oder weniger aufweist, und
bei 25 °C einen pH in einem Bereich von 8,0 bis 12,0 aufweist, 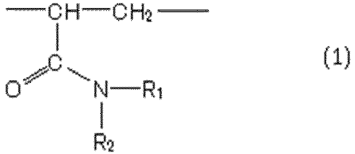
wobei in der obigen allgemeinen Formel (1) R₁ und R₂ jeweils unabhängig voneinander Wasserstoff, eine C₁-Cg-Alkylgruppe oder eine C₁-C₂-Hydroxyalkylgruppe darstellen, wobei R¹ und R² niemals beide Wasserstoff sind.

2. Verfahren zur Herstellung eines Halbleitersubstrats gemäß Anspruch 1, wobei der Gehalt der Komponente C in der flüssigen Polierzusammensetzung für einen Siliziumwafer in einem Bereich von 0,002 bis 0,050 Gew.-% liegt.

3. Verfahren zur Herstellung eines Halbleitersubstrats gemäß Anspruch 1 oder 2, wobei in der allgemeinen Formel (1) die Struktureinheit I mindestens eine Struktureinheit umfasst, die ausgewählt ist aus der Gruppe bestehend aus einer Struktureinheit I-I, in der R₁ und R₂ beide C₁-C₄-Gruppen sind, einer Struktureinheit I-II, in der R₁ ein Wasserstoffatom ist und R₂ eine C₁-C₈-Alkylgruppe ist, und einer Struktureinheit I-III, in der R₁ ein Wasserstoffatom ist und R₂ eine C₁-C₂-Hydroxyalkylgruppe ist.

4. Verfahren zur Herstellung eines Halbleitersubstrats gemäß einem der Ansprüche 1 bis 3, wobei die Struktureinheit I eine Struktureinheit ist, die von mindestens einem Monomer ausgewählt aus der Gruppe bestehend aus *N-*Isopropylacrylamid, *N*-Hydroxyethylacrylamid, *N,N-*Dimethylacrylamid und *N,N*-Diethylacrylamid abgeleitet ist.

5. Verfahren zur Herstellung eines Halbleitersubstrats gemäß einem der Ansprüche 1 bis 4, wobei die Komponente C ferner eine Struktureinheit II umfasst, die durch die allgemeine Formel (2) unten dargestellt ist, und wobei ein Wert, der durch Division des Gewichts der Struktureinheit I durch das Gesamtgewicht der Struktureinheit I und der Struktureinheit II erhalten wird [Gewicht der Struktureinheit I/(Gewicht der Struktureinheit I + Gewicht der Struktureinheit II)], in einem Bereich von 0,1 bis 1 liegt,

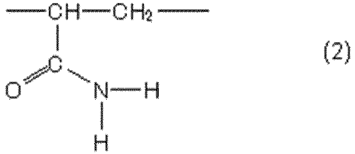

6. Verfahren zur Herstellung eines Halbleitersubstrats gemäß einem der Ansprüche 1 bis 5, wobei die Siliziumdioxidpartikel einen durchschnittlichen Primärpartikeldurchmesser in einem Bereich von 5 bis 50 nm aufweisen.

7. Verfahren zur Herstellung eines Halbleitersubstrats gemäß einem der Ansprüche 1 bis 6, wobei die Siliziumdioxidpartikel kolloidales Siliziumdioxid sind.

8. Verfahren zur Herstellung eines Halbleitersubstrats gemäß einem der Ansprüche 1 bis 7, ferner umfassend ein Alkylenoxidaddukt eines mehrwertigen Alkohols.

9. Verfahren zur Herstellung eines Halbleitersubstrats gemäß einem der Ansprüche 1 bis 8, wobei die flüssige Polierzusammensetzung 0,05 bis 0,5 Gew.-% der Komponente A enthält.

10. Verfahren zur Herstellung eines Halbleitersubstrats gemäß einem der Ansprüche 1 bis 9, umfassend einen Schritt des Verdünnens einer konzentrierten Flüssigkeit vor dem Polierschritt, um eine flüssige Polierzusammensetzung für einen Siliziumwafer zu erhalten.

11. Verfahren zur Herstellung eines Halbleitersubstrats gemäß Anspruch 10, wobei die konzentrierte Flüssigkeit 5 bis 40 Gew.-% der Komponente A, 0,02 bis 5 Gew.-% der Komponente B und 0,005 bis 5 Gew.-% der Komponente C enthält.

12. Verwendung der flüssigen Polierzusammensetzung für einen Siliziumwafer zum Polieren einer Siliziumwaferoberfläche, wobei die flüssige Polierzusammensetzung umfasst:
Siliziumdioxidpartikel (Komponente A);
mindestens eine stickstoffhaltige basische Verbindung (Komponente B) ausgewählt aus der Gruppe bestehend aus einer Aminverbindung und einer Ammoniumverbindung; und eine wasserlösliche, makromolekulare Verbindung (Komponente C), die 10 Gew.-% oder mehr einer Struktureinheit I, dargestellt durch die allgemeine Formel (1) unten, umfasst und ein gewichtsgemitteltes Molekulargewicht von 50.000 oder mehr und 1.500.000 oder weniger aufweist, und
bei 25 °C einen pH in einem Bereich von 8,0 bis 12,0 aufweist, 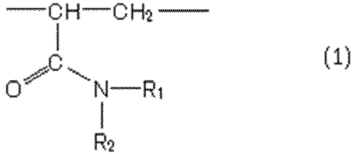
wobei in der obigen allgemeinen Formel (1) R₁ und R₂ jeweils unabhängig voneinander Wasserstoff, eine C₁-C₈-Alkylgruppe oder eine C₁-C₂-Hydroxyalkylgruppe darstellen, wobei R¹ und R² niemals beide Wasserstoff sind.

## Revendications

1. Procédé de fabrication d'un substrat semi-conducteur, comprenant une étape de polissage d'une surface de tranche de silicium au moyen d'une composition liquide de polissage pour une tranche de silicium, comprenant :
des particules de silice (composant A) ;
au moins un composé basique contenant de l'azote (composant B) choisi dans le groupe consistant en un composé d'amine et un composé d'ammonium ; et
un composé macromoléculaire hydrosoluble (composant C) comprenant 10 % en poids ou plus d'un motif constitutionnel I représenté par une formule générale (1) ci-après et présentant une masse moléculaire moyenne en poids de 50 000 ou plus et de 1 500 000 ou moins, et
présentant un pH dans la plage de 8,0 à 12,0 à 25 °C, 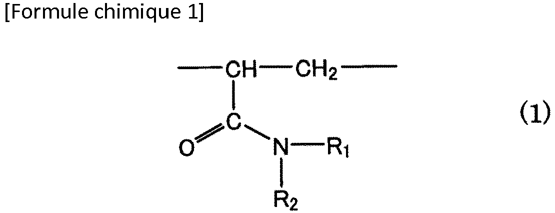
dans la formule générale (1) ci-dessus, R₁ et R₂ représentent chacun indépendamment un hydrogène, un groupe alkyle en C1-C8 ou un groupe hydroxyalkyle en C1-C2, où R₁ et R₂ ne sont jamais tous les deux des hydrogènes.

2. Procédé de fabrication d'un substrat semi-conducteur selon la revendication 1, dans lequel la teneur du composant C dans la composition liquide de polissage pour une tranche de silicium est dans la plage de 0,002 à 0,050 % en poids.

3. Procédé de fabrication d'un substrat semi-conducteur selon la revendication 1 ou 2, dans lequel dans la formule générale (1), le motif constitutionnel I comprend au moins un motif constitutionnel choisi dans le groupe consistant en un motif constitutionnel I-I où R₁ et R₂ sont des groupes alkyle en C1-C4, un motif constitutionnel I-II où R₁ est un atome d'hydrogène et R₂ est un groupe alkyle en C1-C8, et un motif constitutionnel I-III où R₁ est un atome d'hydrogène et R₂ est un groupe hydroxyalkyle en C1-C2.

4. Procédé de fabrication d'un substrat semi-conducteur selon l'une quelconque des revendications 1 à 3, dans lequel le motif constitutionnel I est un motif constitutionnel dérivé d'au moins un monomère choisi dans le groupe consistant en N-isopropylacrylamide, N-hydroxyéthylacrylamide, N,N-diméthylacrylamide et N,N-diéthylacrylamide.

5. Procédé de fabrication d'un substrat semi-conducteur selon l'une quelconque des revendications 1 à 4, dans lequel le composant C comprend en outre un motif constitutionnel II représenté par une formule générale (2) ci-après, et une valeur obtenue en divisant le poids du motif constitutionnel I par la somme totale du poids du motif constitutionnel I et du poids du motif constitutionnel II [poids du motif constitutionnel I / (poids du motif constitutionnel I + poids du motif constitutionnel II)] est dans la plage de 0,1 à 1,

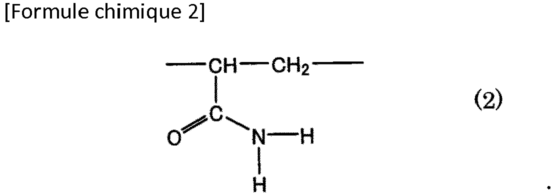

6. Procédé de fabrication d'un substrat semi-conducteur selon l'une quelconque des revendications 1 à 5, dans lequel les particules de silice présentent un diamètre de particule primaire moyen dans la plage de 5 à 50 nm.

7. Procédé de fabrication d'un substrat semi-conducteur selon l'une quelconque des revendications 1 à 6, dans lequel les particules de silice sont de la silice colloïdale.

8. Procédé de fabrication d'un substrat semi-conducteur selon l'une quelconque des revendications 1 à 7, comprenant en outre un adduit d'oxyde d'alkylène d'un alcool polyhydrique.

9. Procédé de fabrication d'un substrat semi-conducteur selon l'une quelconque des revendications 1 à 8, dans lequel la composition liquide de polissage contient 0,05 à 0,5 % en poids du composant A.

10. Procédé de fabrication d'un substrat semi-conducteur selon l'une quelconque des revendications 1 à 9, comprenant une étape de dilution d'un liquide concentré avant l'étape de polissage de sorte à obtenir la composition liquide de polissage pour une tranche de silicium.

11. Procédé de fabrication d'un substrat semi-conducteur selon la revendication 10, dans lequel le liquide concentré contient 5 à 40 % en poids du composant A, 0,02 à 5 % en poids du composant B et 0,005 à 5 % en poids du composant C.

12. Utilisation de la composition liquide de polissage pour une tranche de silicium pour polir une surface de tranche de silicium, dans laquelle la composition liquide de polissage comprend :
des particules de silice (composant A) ;
au moins un composé basique contenant de l'azote (composant B) choisi dans le groupe consistant en un composé d'amine et un composé d'ammonium ; et
un composé macromoléculaire hydrosoluble (composant C) comprenant 10 % en poids ou plus d'un motif constitutionnel I représenté par une formule générale (1) ci-après et présentant une masse moléculaire moyenne en poids de 50 000 ou plus et de 1 500 000 ou moins, et
présentant un pH dans la plage de 8,0 à 12,0 à 25 °C, 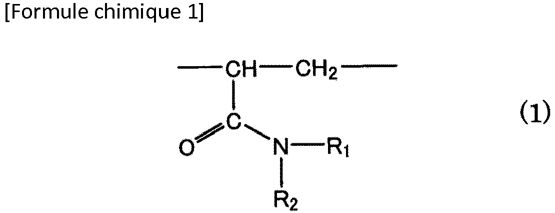
dans la formule générale (1) ci-dessus, R₁ et R₂ représentent chacun indépendamment un hydrogène, un groupe alkyle en C1-C8 ou un groupe hydroxyalkyle en C1-C2, où R₁ et R₂ ne sont jamais tous les deux des hydrogènes.
